# EUROPEAN PATENT SPECIFICATION

(11) **EP 4 200 671 B1**
(45) Date of publication and mention of the grant of the patent: **03.09.2025**
(21) Application number: 21752530.2
(22) Date of filing: 29.07.2021
(51) Int. Cl.: G03F 7/00, G03F 1/36, G06N 20/00, G03F 7/20, G06F 30/30, G06N 3/04

(54) **SYSTEMS AND METHODS FOR IMAGE-BASED PATTERN SELECTION**
SYSTEME UND VERFAHREN ZUR BILDBASIERTEN MUSTERAUSWAHL
SYSTÈMES ET PROCÉDÉS DE SÉLECTION DE MOTIFS SUR LA BASE D'IMAGES

(30) Priority: 19.08.2020 WO PCT/CN2020/110028; 08.02.2021 WO PCT/CN2021/076028
(43) Date of publication of application: 28.06.2023
(73) Proprietor: ASML Netherlands B.V., 5500 AH Veldhoven (NL)
(72) Inventor: SUN, Rencheng, 5500 AH Veldhoven (NL); JIA, Qi, 5500 AH Veldhoven (NL); LIU, Meng, 5500 AH Veldhoven (NL); HU, Weixuan, 5500 AH Veldhoven (NL); WUU, Jen-Yi, San Jose, CA 95134 (US); CHEN, Hao, 5500 AH Veldhoven (NL); LI, Danying, 5500 AH Veldhoven (NL); CHEN, Sheng, 5500 AH Veldhoven (NL)
(74) Representative: ASML Netherlands B.V.
(86) International application number: PCT/EP2021/071359
(87) International publication number: WO 2022/037921

(56) References cited:
- WO-A1-2020/156777
- US-A1- 2019 287 021

## Description

### CROSS-REFERENCE TO RELATED APPLICATIONS

This application claims priority of PCT application PCT/CN2020/110028 which was filed on August 20, 2020 and PCT application PCT/CN2021/076028 which was filed on February 08, 2021.

### TECHNICAL FIELD

The disclosure herein relates generally to semiconductor manufacturing, and more specifically, relates to pattern selection technologies applied in semiconductor manufacturing.

### BACKGROUND

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatuses, the pattern on the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices as described herein can be gleaned, for example, from US 6,046,792.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

As noted, lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced while the amount of functional elements, such as transistors, per device has been steadily increasing over decades, following a trend commonly referred to as "Moore's law". At the current state of technology, layers of devices are manufactured using lithographic projection apparatuses that project a design layout onto a substrate using illumination from a deep-ultraviolet illumination source, creating individual functional elements having dimensions well below 100 nm, i.e. less than half the wavelength of the radiation from the illumination source (e.g., a 193 nm illumination source).

This process in which features with dimensions smaller than the classical resolution limit of a lithographic projection apparatus are printed, is commonly known as low-k1 lithography, according to the resolution formula CD = k1×λ/NA, where λ is the wavelength of radiation employed (currently in most cases 248nm or 193nm), NA is the numerical aperture of projection optics in the lithographic projection apparatus, CD is the "critical dimension"-generally the smallest feature size printed-and k1 is an empirical resolution factor. In general, the smaller k1 the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET). The term "projection optics" as used herein should be broadly interpreted as encompassing various types of optical systems, including refractive optics, reflective optics, apertures and catadioptric optics, for example. The term "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.

WO 2020/156777 A1 and US 2019/287021 A1 disclose background art to the invention.

### SUMMARY

According to the present invention there is provided a non-transitory computer readable medium having instructions that, when executed by a computer, cause the computer to execute a method for selecting patterns for training or calibrating a model to predict patterns to be printed on a substrate through lithography as defined in independent claim 1.

In some embodiments, the grouping includes using different clustering algorithms to identify the group of special patterns and the multiple groups of main patterns.

In some embodiments, grouping the images includes generating feature vectors of the images, wherein each feature vector is representative of the corresponding image.

In some embodiments, grouping the images into the group of special patterns includes (a) determining a minimum distance of each of the feature vectors from any other feature vector of the feature vectors; and (b) identifying those of the feature vectors having the minimum distance above a specified threshold as the group of special patterns.

In some embodiments, generating the multiple groups of main patterns includes (a) determining those of the feature vectors not in the group of special patterns as a set of feature vectors corresponding to main patterns; and (b) clustering the set of feature vectors into the multiple groups of main patterns.

In some embodiments, the method further includes (a) determining, for each group of main patterns, a centroid of the corresponding group of main patterns; and (b) determining, for each group of main patterns, a feature vector that is closest to the centroid as the representative main pattern of the corresponding group of main patterns.

In some embodiments, the method further includes training the model using the images corresponding to the set of patterns to generate a simulated pattern to be printed on the substrate.

In some embodiments, the method further includes generating, using the model, a mask pattern for a given target pattern.

In some embodiments, obtaining the images of the multiple patterns includes obtaining at least one of mask images, aerial images, resist images, etch images of the multiple patterns, which are generated based on pattern data of the multiple patterns.

In some embodiments, the pattern data includes at least one of a full-chip layout data, location data of the multiple patterns in the full-chip layout, or focus exposure matrix data.

According to an embodiment there is provided a non-transitory computer readable medium having instructions that, when executed by a computer, cause the computer to execute a method of pattern selection. The method includes: (a) obtaining images of multiple patterns, wherein the multiple patterns correspond to target patterns to be printed on a substrate; and (b) selecting a set of patterns from the multiple patterns based on the images as training data for training a first model, which can be a machine learning model or a non-machine learning model.

In some embodiments, the selecting includes grouping the multiple patterns into main patterns and special patterns by using different clustering algorithms.

In some embodiments, selecting the set of patterns includes (a) generating feature vectors of the images, wherein each feature vector is representative of the corresponding image; (b) grouping the multiple patterns into multiple groups based on the feature vectors; and (c) selecting the set of patterns from the multiple groups.

In some embodiments, grouping the multiple patterns includes generating a group of special patterns and multiple groups of main patterns from the multiple patterns.

In some embodiments, generating the group of special patterns includes grouping the multiple patterns based on a distance between the feature vectors, wherein a distance between two feature vectors of the feature vectors is indicative of a difference between two patterns in the corresponding two images.

In some embodiments, grouping the multiple patterns based on the distance includes (a) determining a minimum distance of each of the feature vectors from any other feature vector of the feature vectors; and (b) identifying those of the feature vectors having the minimum distance above a specified threshold as the group of special patterns.

In some embodiments, generating the group of special patterns includes (a) clustering the feature vectors based on density-based spatial clustering to identify a set of feature vectors as outliers; and (b) determining patterns in the images corresponding to the set of feature vectors as the group of special patterns.

In some embodiments, generating the multiple groups of main patterns includes (a) determining those of the feature vectors not in the group of special patterns as a set of feature vectors corresponding to main patterns; and (b) clustering the set of feature vectors into the multiple groups of main patterns.

In some embodiments, the clustering is performed using k-means clustering.

In some embodiments, selecting the set of patterns from the multiple groups includes selecting the group of special patterns and a representative main pattern from each group of main patterns.

In some embodiments, selecting the representative main pattern from each group of main patterns includes (a) determining, for each group of main patterns, a centroid of the corresponding group of main patterns; and (b) determining, for each group of main patterns, a feature vector that is closest to the centroid as a representative main pattern of the corresponding group of main patterns.

In some embodiments, the method further includes training the first model using the images corresponding to the group of special patterns and the representative main patterns to generate a simulated pattern to be printed on the substrate.

In some embodiments, the method further includes generating, using the first model, a mask pattern for a given target pattern.

In some embodiments, the method further includes performing a patterning step using the mask pattern to print patterns corresponding to the given target pattern on the substrate via a patterning process.

In some embodiments, generating the feature vectors includes generating a feature vector of an image of the images based on an encoding information obtained from the image.

In some embodiments, the encoding information includes at least one of geometrical information associated with a pattern in the image, resist signals, or optical information associated with a lithographic apparatus used to print the pattern on the substrate.

In some embodiments, generating the feature vectors includes training a second model with a set of pattern images such that a cost function in generating a predicted set of feature vectors for the set of pattern images is reduced.

In some embodiments, training the second model includes (a) executing the second model, using the set of pattern images, to output a predicted feature vector for a first pattern image of the set of pattern images; (b) generating a predicted pattern image from the predicted feature vector; (c) computing the cost function as a difference between the first pattern image and the predicted pattern image; and (d) adjusting parameters of the second model to reduce the cost function.

In some embodiments, the cost function is minimized.

In some embodiments, obtaining the images of the multiple patterns includes obtaining pattern data of the multiple patterns, wherein the pattern data includes at least one of a full-chip layout data, location data of the multiple patterns in the full-chip layout, or focus exposure matric data.

In some embodiments, obtaining the images of the multiple patterns includes generating, using the pattern data, aerial images of the multiple patterns from a source model that is representative of optical properties of a lithographic apparatus.

In some embodiments, obtaining the images of the multiple patterns includes generating, using the pattern data, resist images of the multiple patterns from the aerial images using a resist model.

According to an embodiment, there is provided a method of pattern selection. The method includes: (a) obtaining images of multiple patterns, wherein the multiple patterns correspond to target patterns to be printed on a substrate; and (b) selecting a set of patterns from the multiple patterns based on the images as training data for training a first model.

According to an embodiment there is provided a non-transitory computer readable medium having instructions that, when executed by a computer, cause the computer to execute a method of selecting patterns for training a model to predict patterns to be printed on a substrate. The method includes: obtaining images of multiple patterns, wherein the multiple patterns correspond to target patterns to be printed on a substrate; grouping the images into a group of special patterns and multiple groups of main patterns, wherein the images are grouped into the group of special patterns based on a minimum distance between each of the multiple patterns; obtaining a total number of patterns to be included in a set of patterns, wherein the set of patterns is to be used as training data for training the model; determining a specified number of special patterns to be included in the set of patterns as a function of the minimum distances and the total number of patterns to be included in the set of patterns; and outputting the set of patterns, wherein the set of patterns includes the specified number of special patterns and a representative main pattern from at least one group of main patterns.

According to an embodiment there is provided a non-transitory computer readable medium having instructions that, when executed by a computer, cause the computer to execute a method for selecting patterns for training a model to predict patterns to be printed on a substrate. The method includes: obtaining images of multiple patterns, wherein the multiple patterns correspond to target patterns to be printed on a substrate; obtaining a minimum distance between each of the multiple patterns; determining a threshold minimum distance for selection of a specified number of patterns to be included in a set of patterns, wherein the set of patterns is used as training data for training the model; grouping the patterns into multiple collections based on the threshold minimum distance, wherein each collection includes one or more patterns each having a minimum distance that is below the threshold minimum distance from any other pattern in the collection; selecting at least one pattern from each collection to be included in the set of patterns; and outputting the set of patterns.

According to an embodiment there is provided a non-transitory computer readable medium having instructions that, when executed by a computer, cause the computer to execute a method for selecting patterns for training a model to predict patterns to be printed on a substrate. The method includes: obtaining images of multiple patterns, wherein the multiple patterns correspond to target patterns to be printed on a substrate; obtaining a minimum distance between each of the multiple patterns; determining a threshold minimum distance as a function of the greatest minimum distance of the minimum distances; selecting a specified number of patterns based on the threshold minimum distance; and outputting a set of patterns with the specified number of patterns, wherein the set of patterns is used as training data for training the model.

According to an embodiment there is provided a method of selecting patterns for training a model to predict patterns to be printed on a substrate. The method includes: obtaining images of multiple patterns, wherein the multiple patterns correspond to target patterns to be printed on a substrate; grouping the images into a group of special patterns and multiple groups of main patterns, wherein the images are grouped into the group of special patterns based on a minimum distance between each of the multiple patterns; obtaining a total number of patterns to be included in a set of patterns, wherein the set of patterns is to be used as training data for training the model; determining a specified number of special patterns to be included in the set of patterns as a function of the minimum distances and the total number of patterns to be included in the set of patterns; and outputting the set of patterns, wherein the set of patterns includes the specified number of special patterns and a representative main pattern from at least one group of main patterns.

According to an embodiment there is provided a method for selecting patterns for training a model to predict patterns to be printed on a substrate. The method includes: obtaining images of multiple patterns, wherein the multiple patterns correspond to target patterns to be printed on a substrate; obtaining a minimum distance between each of the multiple patterns; determining a threshold minimum distance for selection of a specified number of patterns to be included in a set of patterns, wherein the set of patterns is used as training data for training the model; grouping the patterns into multiple collections based on the threshold minimum distance, wherein each collection includes one or more patterns each having a minimum distance that is below the threshold minimum distance from any other pattern in the collection; selecting at least one pattern from each collection to be included in the set of patterns; and outputting the set of patterns.

According to an embodiment there is provided a method for selecting patterns for training a model to predict patterns to be printed on a substrate. The method includes: obtaining images of multiple patterns, wherein the multiple patterns correspond to target patterns to be printed on a substrate; obtaining a minimum distance between each of the multiple patterns; determining a threshold minimum distance as a function of the greatest minimum distance of the minimum distances; selecting a specified number of patterns based on the threshold minimum distance; and outputting a set of patterns with the specified number of patterns, wherein the set of patterns is used as training data for training the model.
The first or the second model can be a machine learning model or a non-machine leaning model.The selected patterns resulting from a pattern selection process according to an embodiment of the present disclosure can be used for any suitable purposes without departing from the scope of the present disclosure, such as model training or calibration, simulation, and metrology sampling, for example SEM sampling.

### BRIEF DESCRIPTION OF THE DRAWINGS

Figure 1 shows a block diagram of various subsystems of a lithography system.
Figure 2 shows a flow for a patterning simulation method, according to an embodiment.
Figure 3 shows a flow for a measurement simulation method, according to an embodiment.
Figure 4 is a block diagram of an image-based pattern selection system for selecting patterns for training a model to predict patterns to be printed on a substrate, consistent with various embodiments.
Figure 5A is a flow chart of an exemplary method for image-based selection of patterns, consistent with various embodiments.
Figure 5B is a flow chart of a method for generating an image of a pattern, consistent with various embodiments.
Figure 5C is a flow chart of a method for grouping the pattern images, consistent with various embodiments.
Figure 5D is a flow chart of a method for selecting a set of patterns as training data for training a pattern predictor, consistent with various embodiments.
Figure 6A is a block diagram of a feature vector generator, consistent with various embodiments.
Figure 6B is a block diagram illustrating training of the feature vector generator 410 to generate a feature vector, consistent with various embodiments.
Figure 7 is a block diagram of identification of special patterns using a distance-based method, consistent with various embodiments.
Figure 8 is a block diagram of identification of special patterns using a density-based spatial clustering of applications with noise method, consistent with various embodiments.
Figure 9 is a block diagram for grouping feature vectors into groups of main patterns, consistent with various embodiments.
Figure 10 is a block diagram illustrating selection of patterns from various groups of patterns, consistent with various embodiments.
Figure 11 is a block diagram of an example computer system, according to an embodiment.
Figure 12 is a schematic diagram of a lithographic projection apparatus, according to an embodiment.
Figure 13 is a schematic diagram of another lithographic projection apparatus, according to an embodiment.
Figure 14 is a more detailed view of the apparatus in Figure 12, according to an embodiment.
Figure 15 is a more detailed view of the source collector module SO of the apparatus of Figure 13 and Figure 14, according to an embodiment.
Figure 16 is a block diagram of an exemplary image-based pattern selection system for selecting patterns using a semi-automatic pattern selection mode, consistent with various embodiments.
Figure 17A shows a chart of various categories the patterns are classified into, consistent with various embodiments.
Figure 17B shows a chart of the minimum distances of the patterns and a threshold minimum distance, consistent with various embodiments.
Figure 18 is a block diagram of an exemplary image-based pattern selection system for selecting patterns using a fully-automatic pattern selection mode, consistent with various embodiments.
Figure 19 shows an example of the groups formed based on a threshold minimum distance, consistent with various embodiments.
Figure 20 is a flow chart of an exemplary method for automatic selection of patterns, consistent with various embodiments.
Figure 21A is a flow diagram of an exemplary method for selecting patterns using a semi-automatic pattern selection mode, consistent with various embodiments.
Figure 21B is a flow diagram of an exemplary method for selecting patterns using a fully-automatic pattern selection mode, consistent with various embodiments.

### DETAILED DESCRIPTION

In lithography, a patterning device (e.g., a mask) may provide a mask pattern (e.g., mask design layout) corresponding to a target pattern (e.g., target design layout), and this mask pattern may be transferred onto a substrate by transmitting light through the mask pattern. However, due to various limitations, the transferred pattern may appear with many irregularities and therefore, not be similar to the target pattern. Various enhancement techniques, such as optical proximity correction (OPC), are used in designing the mask pattern to compensate for image errors due to diffraction or other process effects in lithography. Trained or calibrated models are used to predict how patterns printed on a substrate may look like for a given target pattern and corrections may be made to the patterning process (e.g., mask pattern may be modified) based on the predicted patterns to obtained the desired pattern on the substrate. Such a model may be a resist model, an etch model, or a combination thereof Such a model may be a ML model or a non-ML model. Embodiments of the present disclosure may be described in greater details with reference to a ML model, however, the pattern selection mechanism can be used for non-ML models without departing from the scope of the present disclosure. For example, the accuracy of an ML model in predicting the patterns to be printed on the substrate may depend on a coverage of the training data, e.g., a variety of the pattern images, used to train the ML model. However, ML models are liable to overfitting on the training data, that is, failing to extrapolate or predict the patterns for patterns that were unseen during the training, thereby compromising the ML model accuracy. In some cases, the foregoing problem of overfitting may be mitigated by using massive volume of training data. Such approach, however, may not be feasible as it may consume a significant amount of metrology data collection time (e.g., collecting SEM or optical metrology data) and computing resources in collecting pattern images which are needed for the training data.

Current pattern selection process for training data may include a manual pattern selection process in which patterns are selected by tape out experience knowledge. However, there is a risk of missing some key patterns in such a manual process, thereby impacting the coverage of the ML model. Further, the manual selection method involves reviewing all patterns manually which may be time consuming. In some other pattern selection techniques, such as gauge selection tool for focus exposure matrix + (FEM+) model, gauges may be selected based on resist term signal. However, such tools typically process a limited amount of data, which is significantly less than that may be required as the training data. Without good training data, ML models may not cover full chip pattern properties, and may result in defect in the mask pattern (also called as bad pattern coverage). A good pattern selection method may avoid overfitting issue and enhance ML model accuracy and coverage.

In the present disclosure, methods and systems are disclosed for improving pattern selection for training data to train or calibrate a model to predict patterns to be printed on a substrate. In some embodiments, the model is a ML model, a non-ML model, a resist model, an etch model or a combination thereof. For example, the resist model is configure to predict resist images, and the etch model is configured to predict etch images. However, the present disclosure is not limited to any specific type of models that can be trained by using training data of the selected patterns The present disclosure discloses an image-based pattern selection process in which pattern images (e.g., aerial images, mask images,, resist images or etch images) of patterns are generated using pattern data (e.g., full-chip layout data, location data of the multiple patterns in the full-chip layout, or FEM data) and the generated pattern images are processed to select a set of patterns as training data for the ML model. The image-based pattern selection process selects (a) patterns that may be considered as special patterns (e.g., outlier patterns, patterns that are significantly different from other patterns, or patterns whose occurrence is rare compared to the other patterns), and (b) representative patterns that may be similar to the other patterns from the available pattern images. By selecting both special patterns and representative patterns, the image-based selection improves the ML model coverage and therefore, the accuracy in predicting the patterns to be printed on the substrate while using significantly reduced amount of training data. Further, the image-based pattern selection may also help in selecting patterns from a massive data pool more efficiently than known methods. For example, compared to the random pattern selection or gauge selection methods, for a given number of patterns in the data pool, image-based pattern selection may lead to better 2D range and root mean square (RMS) metrics from using the trained machine learning model.

Patterns selected according to embodiments of the present disclosure can also be used to calibrate a non-machine learning model, e.g., a rigorous model, a physical model, an empirical or semi-empirical model, etc. Such model can be a resist model, an etch model, a combination thereof, or any other type of pattern prediction model. In some embodiment, after pattern selection, metrology data of the selected patterns can be acquired and measured by using an inspection or metrology system, and the measured data are used as training data or calibration data of the non-machine learning model. In some embodiments, the metrology system is a SEM system or an optical inspection or metrology system,

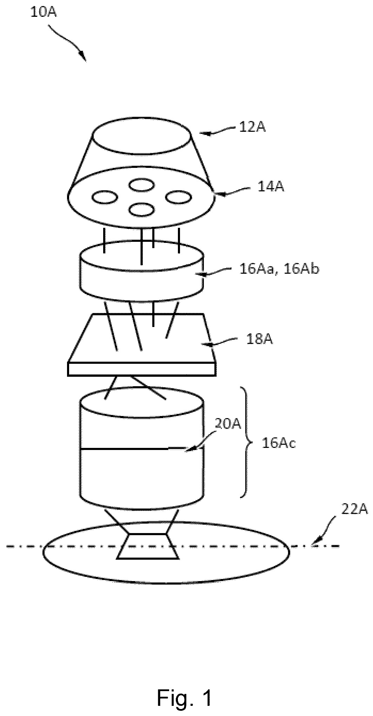

Fig. 1 illustrates an exemplary lithographic projection apparatus 10A. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, e.g., define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin(Θmax), wherein n is the refractive index of the media between the substrate and the last element of the projection optics, and Θmax is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image, an example of which can be found in U.S. Patent Application Publication No. US 2009-0157630. The resist model is related only to properties of the resist layer (e.g., effects of chemical processes which occur during exposure, post-exposure bake (PEB) and development). Optical properties of the lithographic projection apparatus (e.g., properties of the illumination, the patterning device and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251.

The patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. One or more of the design rule limitations may be referred to as "critical dimension" (CD). A critical dimension of a device can be defined as the smallest width of a line or hole or the smallest space between two lines or two holes. Thus, the CD determines the overall size and density of the designed device. Of course, one of the goals in device fabrication is to faithfully reproduce the original design intent on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:
- a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means.
- a programmable LCD array. An example of such a construction is given in U.S. Patent No. 5,229 872.

One aspect of understanding a lithographic process is understanding the interaction of the radiation and the patterning device. The electromagnetic field of the radiation after the radiation passes the patterning device may be determined from the electromagnetic field of the radiation before the radiation reaches the patterning device and a function that characterizes the interaction. This function may be referred to as the mask transmission function (which can be used to describe the interaction by a transmissive patterning device and/or a reflective patterning device).

Variables of a patterning process are called "processing variables." The patterning process may include processes upstream and downstream to the actual transfer of the pattern in a lithography apparatus. A first category may be variables of the lithography apparatus or any other apparatuses used in the lithography process. Examples of this category include variables of the illumination, projection system, substrate stage, etc. of a lithography apparatus. A second category may be variables of one or more procedures performed in the patterning process. Examples of this category include focus control or focus measurement, dose control or dose measurement, bandwidth, exposure duration, development temperature, chemical composition used in development, etc. A third category may be variables of the design layout and its implementation in, or using, a patterning device. Examples of this category may include shapes and/or locations of assist features, adjustments applied by a resolution enhancement technique (RET), CD of mask features, etc. A fourth category may be variables of the substrate. Examples include characteristics of structures under a resist layer, chemical composition and/or physical dimension of the resist layer, etc. A fifth category may be characteristics of temporal variation of one or more variables of the patterning process. Examples of this category include a characteristic of high frequency stage movement (e.g., frequency, amplitude, etc.), high frequency laser bandwidth change (e.g., frequency, amplitude, etc.) and/or high frequency laser wavelength change. These high frequency changes or movements are those above the response time of mechanisms to adjust the underlying variables (e.g., stage position, laser intensity). A sixth category may be characteristics of processes upstream of, or downstream to, pattern transfer in a lithographic apparatus, such as spin coating, post-exposure bake (PEB), development, etching, deposition, doping and/or packaging.

As will be appreciated, many, if not all of these variables, will have an effect on a parameter of the patterning process and often a parameter of interest. Non-limiting examples of parameters of the patterning process may include critical dimension (CD), critical dimension uniformity (CDU), focus, overlay, edge position or placement, sidewall angle, pattern shift, etc. Often, these parameters express an error from a nominal value (e.g., a design value, an average value, etc.). The parameter values may be the values of a characteristic of individual patterns or a statistic (e.g., average, variance, etc.) of the characteristic of a group of patterns.

The values of some or all of the processing variables, or a parameter related thereto, may be determined by a suitable method. For example, the values may be determined from data obtained with various metrology tools (e.g., a substrate metrology tool). The values may be obtained from various sensors or systems of an apparatus in the patterning process (e.g., a sensor, such as a leveling sensor or alignment sensor, of a lithography apparatus, a control system (e.g., a substrate or patterning device table control system) of a lithography apparatus, a sensor in a track tool, etc.). The values may be from an operator of the patterning process.

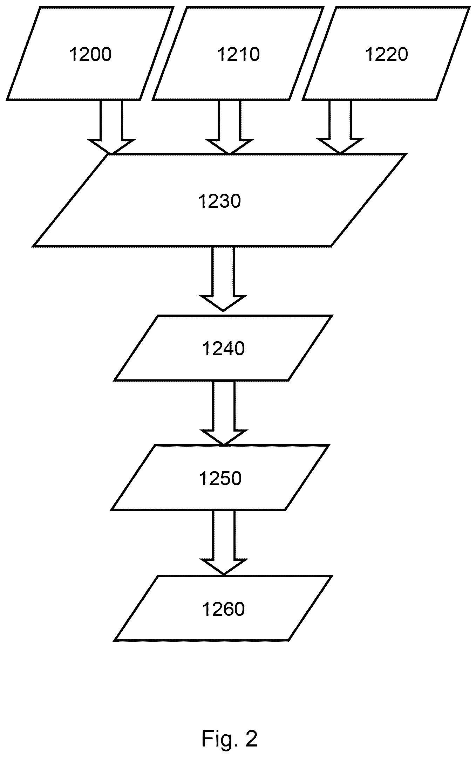

An exemplary flow chart for modelling and/or simulating parts of a patterning process is illustrated in Figure 2. As will be appreciated, the models may represent a different patterning process and need not comprise all the models described below. A source model 1200 represents optical characteristics (including radiation intensity distribution, bandwidth and/or phase distribution) of the illumination of a patterning device. The source model 1200 can represent the optical characteristics of the illumination that include, but not limited to, numerical aperture settings, illumination sigma (σ) settings as well as any particular illumination shape (e.g. off-axis radiation shape such as annular, quadrupole, dipole, etc.), where σ (or sigma) is outer radial extent of the illuminator.

A projection optics model 1210 represents optical characteristics (including changes to the radiation intensity distribution and/or the phase distribution caused by the projection optics) of the projection optics. The projection optics model 1210 can represent the optical characteristics of the projection optics, including aberration, distortion, one or more refractive indexes, one or more physical sizes, one or more physical dimensions, etc.

The patterning device / design layout model module 1220 captures how the design features are laid out in the pattern of the patterning device and may include a representation of detailed physical properties of the patterning device, as described, for example, in U.S. Patent No. 7,587704. In an embodiment, the patterning device / design layout model module 1220 represents optical characteristics (including changes to the radiation intensity distribution and/or the phase distribution caused by a given design layout) of a design layout (e.g., a device design layout corresponding to a feature of an integrated circuit, a memory, an electronic device, etc.), which is the representation of an arrangement of features on or formed by the patterning device. Since the patterning device used in the lithographic projection apparatus can be changed, it is desirable to separate the optical properties of the patterning device from the optical properties of the rest of the lithographic projection apparatus including at least the illumination and the projection optics. The objective of the simulation is often to accurately predict, for example, edge placements and CDs, which can then be compared against the device design. The device design is generally defined as the pre-OPC patterning device layout, and will be provided in a standardized digital file format such as GDSII or OASIS.

An aerial image 1230 can be simulated from the source model 1200, the projection optics model 1210 and the patterning device / design layout model 1220. An aerial image (AI) is the radiation intensity distribution at substrate level. Optical properties of the lithographic projection apparatus (e.g., properties of the illumination, the patterning device and the projection optics) dictate the aerial image.

A resist layer on a substrate is exposed by the aerial image and the aerial image is transferred to the resist layer as a latent "resist image" (RI) therein. The resist image (RI) can be defined as a spatial distribution of solubility of the resist in the resist layer. A resist image 1250 can be simulated from the aerial image 1230 using a resist model 1240. The resist model can be used to calculate the resist image from the aerial image, an example of which can be found in U.S. Patent Application Publication No. US 2009-0157360. The resist model typically describes the effects of chemical processes which occur during resist exposure, post exposure bake (PEB) and development, in order to predict, for example, contours of resist features formed on the substrate and so it typically related only to such properties of the resist layer (e.g., effects of chemical processes which occur during exposure, post-exposure bake and development). In an embodiment, the optical properties of the resist layer, e.g., refractive index, film thickness, propagation and polarization effects- may be captured as part of the projection optics model 1210.

So, in general, the connection between the optical and the resist model is a simulated aerial image intensity within the resist layer, which arises from the projection of radiation onto the substrate, refraction at the resist interface and multiple reflections in the resist film stack. The radiation intensity distribution (aerial image intensity) is turned into a latent "resist image" by absorption of incident energy, which is further modified by diffusion processes and various loading effects. Efficient simulation methods that are fast enough for full-chip applications approximate the realistic 3-dimensional intensity distribution in the resist stack by a 2-dimensional aerial (and resist) image.

In an embodiment, the resist image can be used an input to a post-pattern transfer process model module 1260. The post-pattern transfer process model 1260 defines performance of one or more post-resist development processes (e.g., etch, development, etc.).

Simulation of the patterning process can, for example, predict contours, CDs, edge placement (e.g., edge placement error), etc. in the resist and/or etched image. Thus, the objective of the simulation is to accurately predict, for example, edge placement, and/or aerial image intensity slope, and/or CD, etc. of the printed pattern. These values can be compared against an intended design to, e.g., correct the patterning process, identify where a defect is predicted to occur, etc. The intended design is generally defined as a pre-OPC design layout which can be provided in a standardized digital file format such as GDSII or OASIS or other file format.

Thus, the model formulation describes most, if not all, of the known physics and chemistry of the overall process, and each of the model parameters desirably corresponds to a distinct physical or chemical effect. The model formulation thus sets an upper bound on how well the model can be used to simulate the overall manufacturing process.

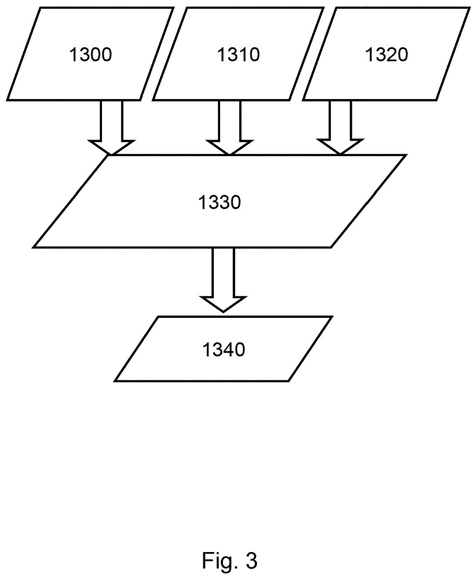

An exemplary flow chart for modelling and/or simulating a metrology process is illustrated in Figure 3. As will be appreciated, the following models may represent a different metrology process and need not comprise all the models described below (e.g., some may be combined). A source model 1300 represents optical characteristics (including radiation intensity distribution, radiation wavelength, polarization, etc.) of the illumination of a metrology target. The source model 1300 can represent the optical characteristics of the illumination that include, but not limited to, wavelength, polarization, illumination sigma (σ) settings (where σ (or sigma) is a radial extent of illumination in the illuminator), any particular illumination shape (e.g. off-axis radiation shape such as annular, quadrupole, dipole, etc.), etc.

A metrology optics model 1310 represents optical characteristics (including changes to the radiation intensity distribution and/or the phase distribution caused by the metrology optics) of the metrology optics. The metrology optics 1310 can represent the optical characteristics of the illumination of the metrology target by metrology optics and the optical characteristics of the transfer of the redirected radiation from the metrology target toward the metrology apparatus detector. The metrology optics model can represent various characteristics involving the illumination of the target and the transfer of the redirected radiation from the metrology target toward the detector, including aberration, distortion, one or more refractive indexes, one or more physical sizes, one or more physical dimensions, etc.

A metrology target model 1320 can represent the optical characteristics of the illumination being redirected by the metrology target (including changes to the illumination radiation intensity distribution and/or phase distribution caused by the metrology target). Thus, the metrology target model 1320 can model the conversion of illumination radiation into redirected radiation by the metrology target. Thus, the metrology target model can simulate the resulting illumination distribution of redirected radiation from the metrology target. The metrology target model can represent various characteristics involving the illumination of the target and the creation of the redirected radiation from the metrology, including one or more refractive indexes, one or more physical sizes of the metrology, the physical layout of the metrology target, etc. Since the metrology target used can be changed, it is desirable to separate the optical properties of the metrology target from the optical properties of the rest of the metrology apparatus including at least the illumination and projection optics and the detector. The objective of the simulation is often to accurately predict, for example, intensity, phase, etc., which can then be used to derive a parameter of interest of the patterning process, such overlay, CD, focus, etc.

A pupil or aerial image 1330 can be simulated from the source model 1300, the metrology optics model 1310 and the metrology target model 1320. A pupil or aerial image is the radiation intensity distribution at the detector level. Optical properties of the metrology optics and metrology target (e.g., properties of the illumination, the metrology target and the metrology optics) dictate the pupil or aerial image.

A detector of the metrology apparatus is exposed to the pupil or aerial image and detects one or more optical properties (e.g., intensity, phase, etc.) of the pupil or aerial image. A detection model module 1320 represents how the radiation from the metrology optics is detected by the detector of the metrology apparatus. The detection model can describe how the detector detects the pupil or aerial image and can include signal to noise, sensitivity to incident radiation on the detector, etc. So, in general, the connection between the metrology optics model and the detector model is a simulated pupil or aerial image, which arises from the illumination of the metrology target by the optics, redirection of the radiation by the target and transfer of the redirected radiation to the detectors. The radiation distribution (pupil or aerial image) is turned into detection signal by absorption of incident energy on the detector.

Simulation of the metrology process can, for example, predict spatial intensity signals, spatial phase signals, etc. at the detector or other calculated values from the detection system, such as an overlay, CD, etc. value based on the detection by the detector of the pupil or aerial image. Thus, the objective of the simulation is to accurately predict, for example, detector signals or derived values such overlay, CD, corresponding to the metrology target. These values can be compared against an intended design value to, e.g., correct the patterning process, identify where a defect is predicted to occur, etc.

Thus, the model formulation describes most, if not all, of the known physics and chemistry of the overall metrology process, and each of the model parameters desirably corresponds to a distinct physical and/or chemical effect in the metrology process.

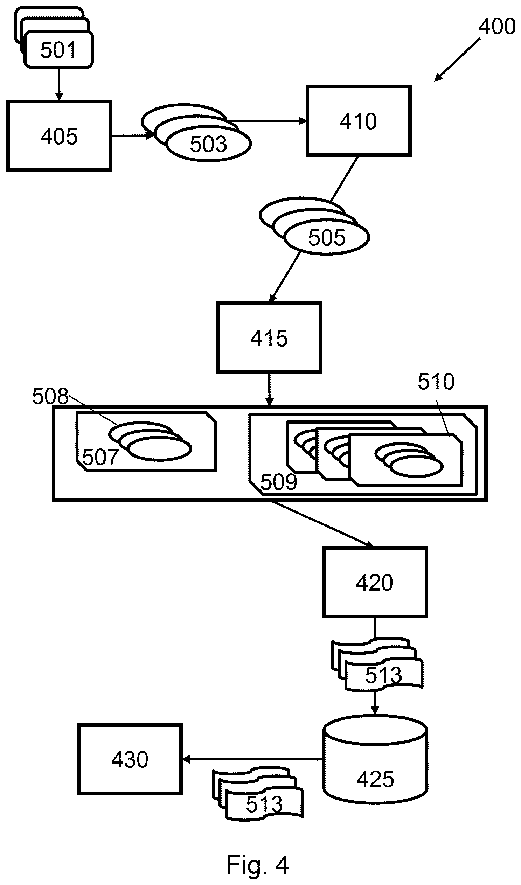

Figure 4 is a block diagram of an exemplary image-based pattern selection system 400 for selecting patterns for training a model to predict patterns to be printed on a substrate, consistent with various embodiments. The image-based pattern selection system 400 includes an image generator 405, a feature vector generator 410, a grouping component 415, a pattern selector 420, data storage system 425, and a pattern predictor 430. The image generator 405 obtains pattern data 501 of multiple patterns and generates pattern images 503 using the pattern data 501. Typically, a pattern can include several instances of one or more features (e.g., 106 instances of feature A, 104 instances of feature B, etc.) arranged in a certain manner to form the pattern. The pattern images 503 can be aerial images, which may be generated using a source model (e.g., source model 1200 described above), or can be resist images, which may be generated using a resist model (e.g., resist model 1240 described above), or any other suitable images resulting from simulation. The pattern data 501 can include full-chip layout data, location data of the multiple patterns in the full-chip layout, or FEM data. The pattern data 501 can be obtained from a standardized digital file format such as GDSII or OASIS, which may be available at the data storage system 425.

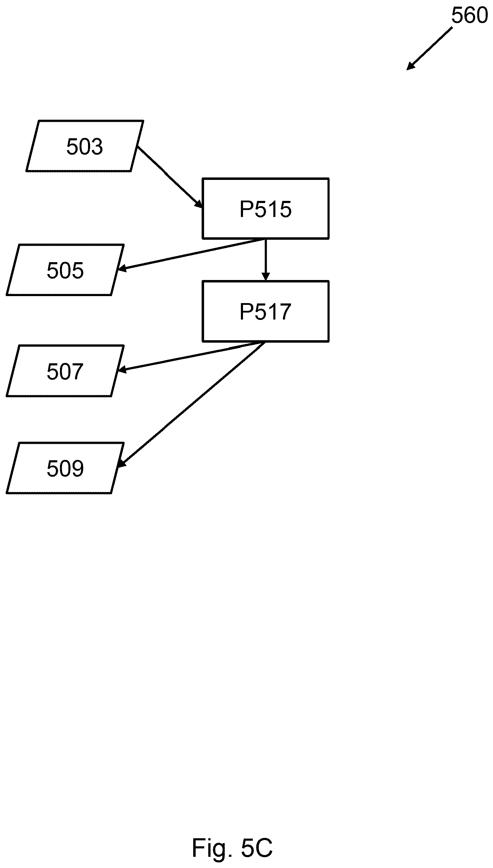

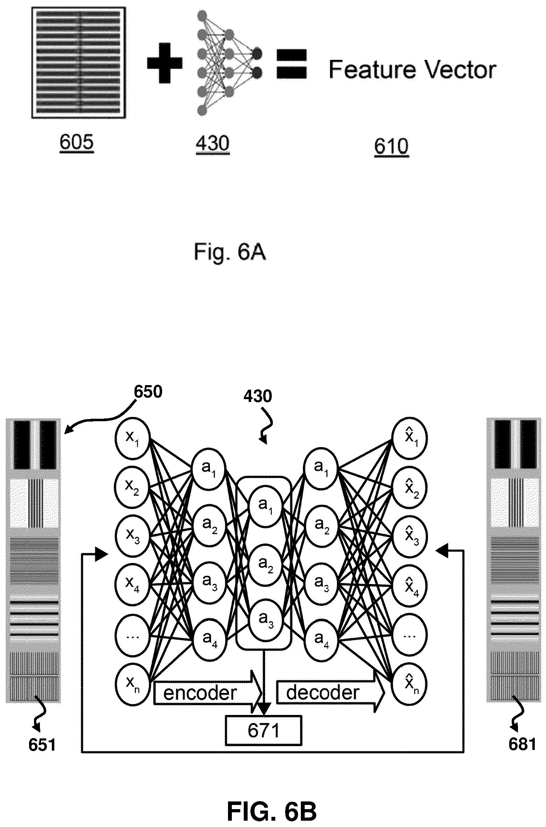

The feature vector generator 410 may generate feature vectors 505 for the pattern images 503. In some embodiments, a feature vector is a vector that represents some object (e.g., a pattern image). In some embodiments, a feature vector is a vector of numbers that may describe a pattern in the pattern image. Some example features of the pattern image that may be described using the feature vector includes any of geometrical information associated with a pattern in the image (e.g., dimension, size, position of a feature in the pattern), resist signals, or optical information associated with a lithographic apparatus used to print the pattern on the substrate (e.g., slope of the aerial image intensity, "edge slope" or "normalized image log slope," often abbreviated as "NILS" (which indicates a lack of sharpness or image blur, where the edge of the resist feature is expected)). The dimension of the feature vector depends on a neural network or other ML model used to implement the feature vector generator 410. Additional details with respect to feature vector generation is described at least with reference to Figs 5C, 6A and 6B.

The grouping component 415 may group the feature vectors 505 into a group of special patterns 507 and multiple groups of main patterns 509. In some embodiments, a special pattern, such as the special pattern 508, is a pattern that is significantly different from the other patterns in the pattern images 503. In some embodiments, a group of main patterns, such as a first group of main patterns 510, includes those patterns from the pattern images 503 that are similar to one another. The grouping component 415 may use any of a number of clustering algorithms/methods to identify the group of special patterns 507 and groups of main patterns 509. For example, the grouping component 415 may use a distance-based method or density-based spatial clustering of applications with noise (DBSCAN) method on the feature vectors 505 in identifying the feature vectors that are significantly different the other feature vectors as special patterns among the pattern images 503. Further, the grouping component 415 may use k-means clustering to group those of the feature vectors 505 that are not in the group of special patterns 507 into multiple groups of main patterns 509. Additional details with respect to grouping of the feature vectors 505 is described at least with reference to Figs 5C and 7-10.

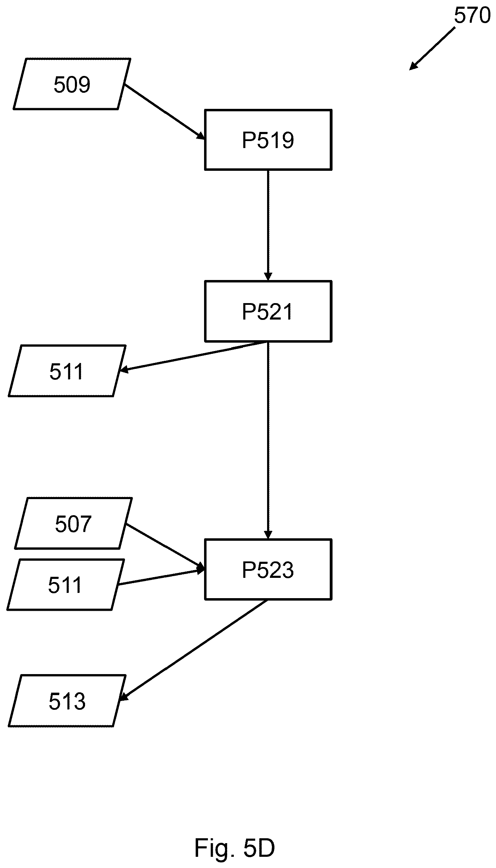

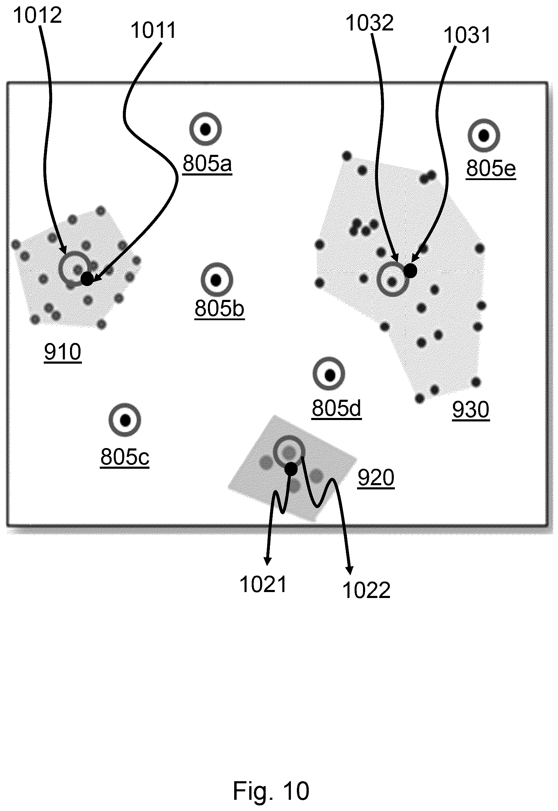

The pattern selector 420 selects a set of patterns 513 from the group of special patterns 507 and the groups of main patterns 509. In some embodiments, the pattern selector 420 selects all special patterns 507 and a representative main pattern from each group of the groups of main patterns 509 as the set of patterns 513. For example, if there are (a) five patterns in the group of special patterns 507 and (b) three groups of main patterns 509, the pattern selector 420 may select eight patterns as the set of patterns 513, which includes five special patterns and three representative main patterns (one representative pattern from each of the three groups of main patterns 509). Additional details with respect to selecting the set of patterns 513 are described at least with reference to Figs. 5D and 10. The feature vectors 505 corresponding to the selected set of patterns 513 may be stored in the data storage system 425, and may be used as training data for training the pattern predictor 430 to predict a pattern to be printed on the substrate for any given target pattern. In some embodiments, the pattern selector 420 may input pattern images 503 corresponding to the set of patterns 513 as training data for the pattern predictor 430. The pattern predictor 430 may be implemented as a ML model. In some embodiments, by selecting both the special patterns and representative patterns as the training data, a coverage of the pattern predictor 430 and therefore, the accuracy in predicting the patterns to be printed on the substrate is improved.

The trained pattern predictor 430 may be used in generating a mask pattern for any given target pattern, and this mask pattern may be transferred onto a substrate by transmitting light through the mask pattern.

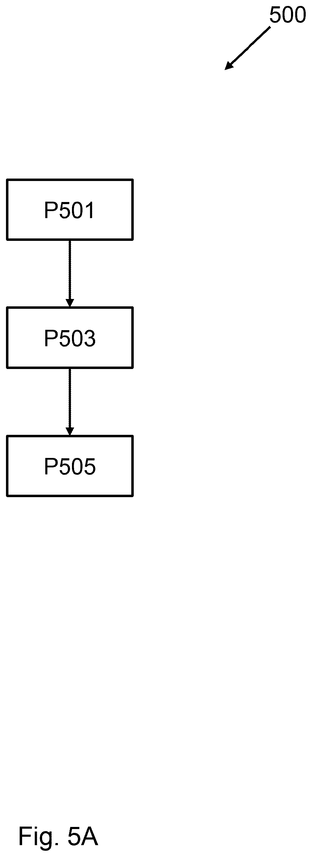

Figure 5A is a flow chart of an exemplary method 500 for image-based selection of patterns, consistent with various embodiments. In some embodiments, the method 500 may be implemented by the system 400 of FIG. 4.

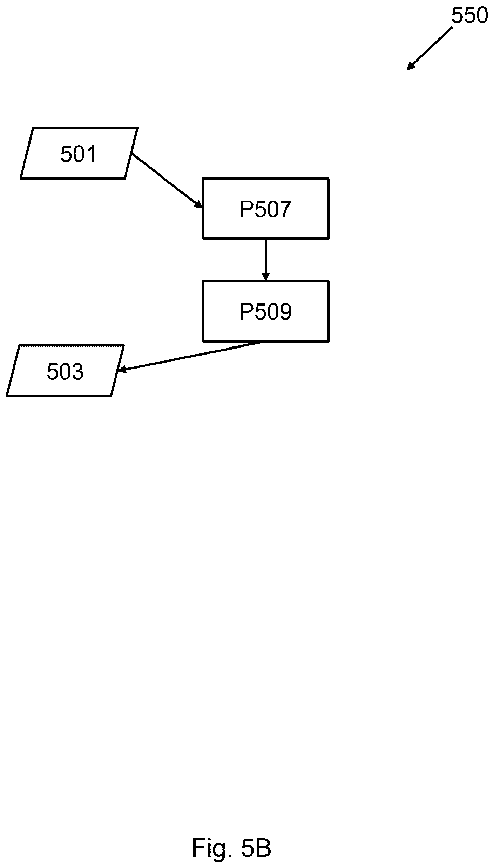

At process P501, pattern images of multiple patterns are obtained. The pattern images can be, a form of mask images, aerial images, resist images or etch images of the patterns. Additional details of obtaining the pattern images are described at least with reference to process 550 of FIG. 5B.

At process P503, the pattern images are grouped into a group of special patterns and multiple groups of main patterns. In some embodiments, a special pattern, such as the special pattern 508, is a pattern that is significantly different from the other patterns in the pattern images. In some embodiments, a group of main patterns, such as a first group of main patterns 510, are a set of patterns in the pattern images that are similar. The grouping may be performed using any of a number of clustering methods. Additional details with respect to grouping of the patterns are described at least with reference to process 560 of FIG. 5C.

At process P505, a set of patterns are selected from the group of special patterns and the groups of main patterns. In some embodiments, all special patterns, and a representative main pattern from each group of the groups of main patterns are selected as the set of patterns. Additional details with respect to grouping of the patterns are described at least with reference to process 570 of FIG. 5D.

Figure 5B is a flow chart of a method 550 for generating an image of a pattern, consistent with various embodiments. In some embodiments, the process 550 is performed as part of the process P501 of the process 500. At process P507, the image generator 405 obtains pattern data 501 of multiple patterns. The pattern data 501 may include one or more of full-chip layout data, location data of the multiple patterns in the full-chip layout, or FEM data. The pattern data 501 can be obtained from a standardized digital file format such as GDSII or OASIS, which may be available at the data storage system 425.

At process P509, the image generator 405 generates an image ("pattern image") for each of the patterns using the pattern data 501, such as pattern images 503. In some embodiments, the image may be an aerial image, which as described as above, is the radiation intensity distribution at substrate level. The image generator 405 may generate the aerial image using a source model, which represents optical characteristics of a lithographic apparatus used to print the pattern on a substrate. In some embodiments, the image may be a resist image, which as described above, is a spatial distribution of solubility of the resist in the resist layer. The image generator 405 may simulate a resist image from the aerial image using a resist model, which is related to properties of the resist layer (e.g., effects of chemical processes which occur during exposure, post-exposure bake (PEB) and development). The aerial image may include any of geometrical information associated with a pattern in the image (e.g., dimension, size, position of a feature in the pattern), resist signals, or optical information associated with a lithographic apparatus used to print the pattern on the substrate (e.g., slope of the aerial image intensity, image log slope (ILS), NILS), which may be useful in selecting special patterns.

In some embodiments, mask images, aerial images, resist images or etch images are chosen as the pattern images for performing image-based pattern selection because the training data input to the pattern predictor 430 is aerial images or resist images. So, by using the aerial images or resist images for performing the image-based pattern selection, the images can be reused for training the pattern predictor 430 eliminating the need for generating different types of images for both these processes, thereby minimizing the amount of computing resources consumed in selecting the patterns and training the pattern predictor 430 using the selected patterns. Further, compared with target layout, aerial images, mask images, resist images or etch images incorporate various physical, chemical and optical effects from the fabrication processes, such as resist signals, diffraction at feature edges, interference among edges, features and patterns in that would occur the lithography system. Therefore, pattern selection based on these images can advantageously lead to more accurate trained model. Figure 5C is a flow chart of a method 560 for grouping the pattern images, consistent with various embodiments. In some embodiments, the process 560 is performed as part of the process P503 of the process 500. At process P515, the feature vector generator 410 may generate a feature vector for each of the pattern images 503, such as the feature vectors 505. In some embodiments, a feature vector is a vector that represents some object (e.g., a pattern image). For example, a feature vector may be a vector of numbers that may describe a pattern in the pattern image. Some example features of the pattern image that may be described using the feature vector includes any of geometrical information associated with a pattern in the image (e.g., dimension, size, position of a feature in the pattern), resist signals, or optical information associated with the lithographic apparatus used to print the pattern on the substrate (e.g., slope of the aerial image intensity, ILS, NILS).

Figure 6A is a block diagram of a feature vector generator, consistent with various embodiments. In some embodiments, the feature vector generator 410 may be implemented using a ML model that is trained to generate a feature vector, such as the feature vector 610, for any given pattern image, such as the pattern image 605. The feature vector generator 410 takes as input the pattern image 605, which can be similar to one of the pattern images 503, and generates the feature vector 610, which can be similar to one of the feature vectors 505. The dimension of the feature vector depends on a neural network or other ML model used to implement the feature vector generator 410. In order for the feature vector generator 410 to generate the feature vector 610, the feature vector generator 410 may have to be trained.

Figure 6B is a block diagram illustrating training of the feature vector generator 410 to generate a feature vector, consistent with various embodiments. The feature vector generator 410 is trained using a number of pattern images 650. The training process is an iterative process and the iterations may be performed until a cost function associated with the feature vector generator 410 is reduced (e.g., minimized). An iteration of the training process may include inputting a pattern image, such as the pattern image 651, to the feature vector generator 410, generating a feature vector, such as the feature vector 671, from the pattern image 651, simulating or predicting a pattern image, such as the pattern image 681 from the generated feature vector 671, comparing the difference between the input pattern image 651 and the predicted pattern image 681 to, which is indicative of the difference, and adjusting ML model parameters of the feature vector generator 410 to reduce the cost function (e.g., minimize). The training may be continued, that is, the above iterations may be repeated, with different pattern images from the pattern images 650 until the cost function is minimized. The feature vector generator 410 may be considered to be trained when the cost function is minimized, and may then be used to generate a feature vector for any given pattern image.

In some embodiments, a feature vector is generated based on the information encoded in a pattern image. The feature vector generator 410 extracts the encoded information and generates the feature vector based on the extracted information. The encoded information may include any of geometrical information associated with a pattern in the image (e.g., dimension, size, position of a feature in the pattern), resist signals, or optical information associated with the lithographic apparatus used to print the pattern on the substrate (e.g., slope of the aerial image intensity, ILS, NILS).

In some embodiments, the feature vectors may also reduce the dimension of the input pattern images. For example, if the input pattern image is of X*Y pixels, the feature vector can reduce the dimension to A*B pixels, where A<X and B<Y. Further, in some embodiments, with different cost functions and neural network schema, the feature vector generator 410 may generate different kinds of image feature vectors, which can be used in different clustering algorithms/methods.

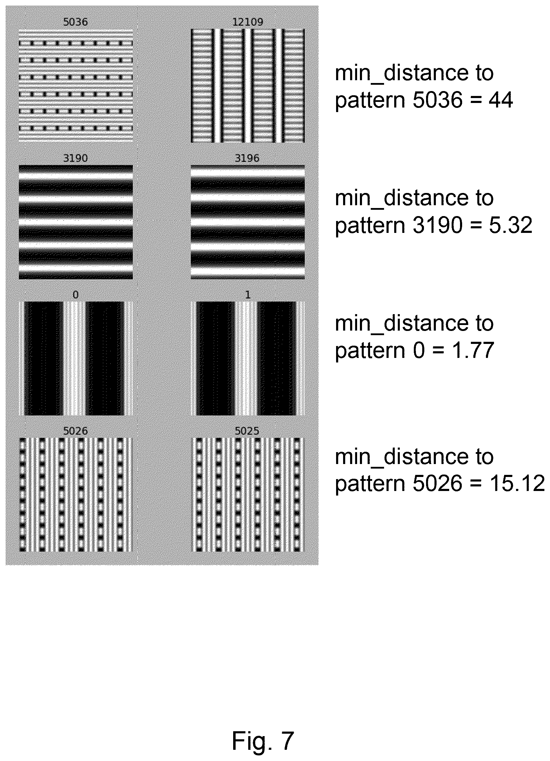

Referring to process P515, after generating the feature vectors 505, at process P517, the grouping component 415 groups the feature vectors 505 into a group of special patterns 507 and multiple groups of main patterns 509. As described above, a special pattern is a pattern that is significantly different from the other patterns in the pattern images 503. The grouping component 415 may use any of a number of clustering methods to identify the group of special patterns 507. For example, the grouping component 415 may use a distance-based method to identify patterns that are significantly different from the other patterns in the pattern images 503 as special patterns, as illustrated in FIG. 7.

Figure 7 is a block diagram of identification of special patterns using a distance-based method, consistent with various embodiments. In the distance-based method, the grouping component 415 determines a minimum distance between two feature vectors. The distance is indicative of a difference between the two corresponding patterns. The grouping component 415 may determine the distance between a specific pattern image in the pattern images 503 to one or more of the remaining pattern images 503. For example, the grouping component 415 determines a minimum distance of the pattern image 12109 to pattern image 5036 as "44" units. Similarly, the grouping component 415 determines a minimum distance of pattern image 3196 to pattern image 3190 as "5.32" units. The grouping component 415 may use any of a number of methods to determine the distance. After determining the minimum distances between pairs of feature vectors, the grouping component 415 may select those feature vectors having a minimum distance above a specified threshold as the group of special patterns 507. For example, if the specified threshold for the minimum distance is "20" units, the grouping component 415 may select all feature vectors whose minimum distances to the feature vectors they are compared with are above "20" units as the special pattern 507, such as the feature vector corresponding to pattern image 12109 (which is the only pattern image having a distance above "20" units). In some embodiments, the grouping component 415 may sort the feature vector pairs in a descending order, e.g., from highest minimum distance to lowest minimum distance, and may select top "n" number of feature vectors as the special patterns 507. For example, if the feature vector pairs with top three minimum distances is to be selected, the grouping component 415 may select the feature vectors corresponding to the pattern image 12109, pattern image 5025, and pattern image 3196 as the special patterns 507.

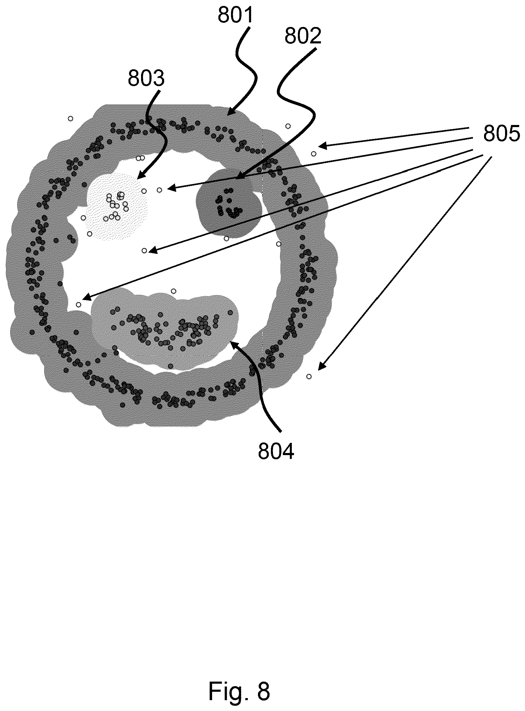

DBSCAN is another method of identifying the special patterns 507. Figure 8 is a block diagram of identification of special patterns using a DBSCAN method, consistent with various embodiments. In the DBSCAN method, the grouping component 415 clusters the feature vectors 505 using DBSCAN algorithm, which generates one or more clusters of the pattern images, such as clusters 801, 802, 803, and 804. Each cluster may include feature vectors of pattern images that are similar to one another within the cluster. The outliers, e.g., the pattern images that do not belong to any of the clusters 801-804, such as pattern images 805, may be identified as the group of special patterns 507.

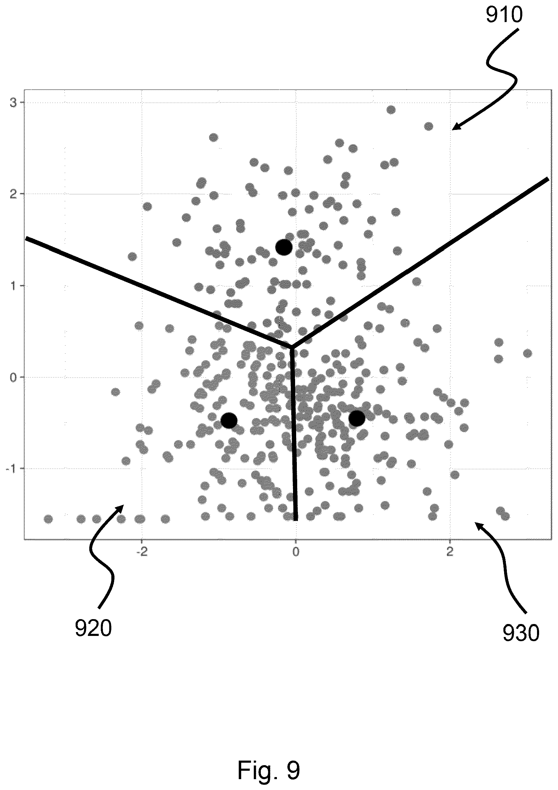

Continuing with process P517, after identifying the special patterns 507, the grouping component 415 may group the remaining feature vectors, e.g., those of the feature vectors 505 that are not identified as special patterns, into multiple groups of main patterns 509. The grouping component 415 may use any of a number of methods to group the main patterns. For example, the grouping component 415 may use k-means clustering to group the feature vectors 505 into multiple groups of main patterns 509, as illustrated in FIG. 9.

Figure 9 is a block diagram for grouping feature vectors into groups of main patterns, consistent with various embodiments. The grouping component 415 uses k-means clustering to group those of the feature vectors 505 that are not identified as special patterns, into multiple clusters, such as a first cluster 910, a second cluster 920 and a third cluster 930. Each cluster may include feature vectors pattern images that are similar to one another within the cluster. The clusters 910-930 may be considered as the groups of main patterns 509.

Figure 5D is a flow chart of a method 570 for selecting a set of patterns as training data for training a pattern predictor, consistent with various embodiments. In some embodiments, the process 570 is performed as part of the process P505 of the process 500. At process P519, the pattern selector 420 determines a centroid of each of the groups of main patterns 509. In some embodiments, a centroid is a data point (imaginary or real) at the center of a cluster, as illustrated in FIG. 10. Figure 10 is a block diagram illustrating selection of patterns from various groups of patterns, consistent with various embodiments. As illustrated in Figure 10, the groups of main patterns 509 may include the first cluster of main patterns 910, the second cluster of main patterns 920, and the third cluster of main patterns 930. The pattern selector 420 determines a centroid of each cluster. For example, the pattern selector 420 determines a first centroid 1011 of the first cluster 910, a second centroid 1021 of the second cluster 920, and a third centroid 1031 of the third cluster 930.

At process P521, the pattern selector 420 selects a representative main pattern from each of the clusters of the main patterns. In some embodiments, the pattern selector 420 selects a feature vector that is closest to a centroid of the cluster as the representative main pattern from that cluster. For example, the pattern selector 420 selects a first representative main pattern 1012 that is closest to the first centroid 1011, a second representative main pattern 1022 that is closest to the second centroid 1021, and a third representative main pattern 1032 that is closest to the third centroid 1031. The representative main patterns 1012, 1022 and 1032 are selected as a group of representative main patterns 511.

At process P523, the pattern selector 420 selects group of special patterns 507 and the group of representative main patterns 511 as the set of patterns 513 as training data for training the pattern predictor 430. In some embodiments, the training data input to the pattern predictor 430 includes pattern images 503 corresponding to the feature vectors in the selected set of patterns 513. In some embodiments, the group of special patterns 507 includes the special patterns 805a-e (which are patterns that are not part of any of the clusters 910-930 and are determined as described at least with reference to Figs 7 and 8).

In some embodiments, the pattern predictor 430 comprises a resist model, an etch model or a combination thereof. In some embodiments, the pattern predictor 430 may be a ML model or a non-ML model that are trained or calibrated by the training data of the patterns 513.

In some embodiments, the pattern selector is a non-machine learning model, e.g., a rigorous model, a physical model, an empirical or semi-empirical model, etc. In some embodiment, after pattern selection, metrology data of the selected patterns can be acquired and measured by using an inspection or metrology system, and the measured data are used as training data or calibration data of the non-machine learning model. In some embodiments, the metrology system is a SEM system or an optical inspection or metrology system,

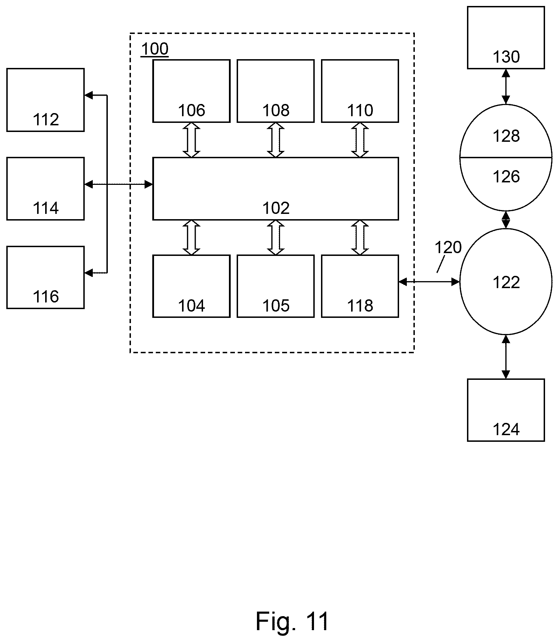

Fig. 11 is a block diagram that illustrates a computer system 100 which can assist in implementing the methods, flows, modules, components, or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random-access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

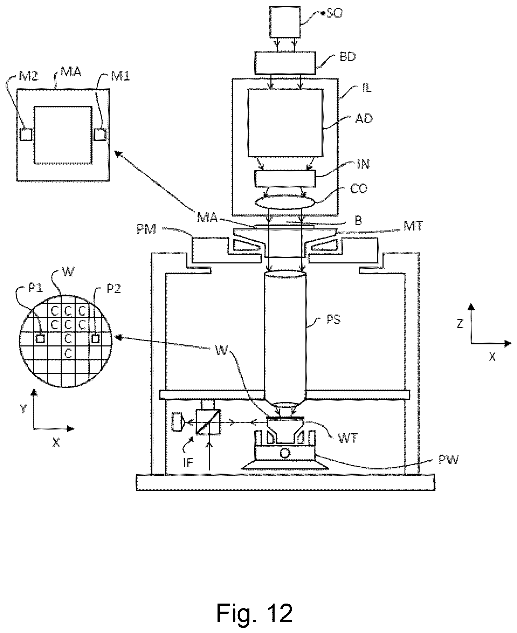

Fig. 12 depicts an exemplary lithographic projection apparatus in conjunction with the techniques described herein can be utilized. The apparatus comprises:
- an illumination system IL, to condition a beam B of radiation. In this particular case, the illumination system also comprises a radiation source SO;
- a first object table (e.g., patterning device table) MT provided with a patterning device holder to hold a patterning device MA (e.g., a reticle), and connected to a first positioner to accurately position the patterning device with respect to item PS;
- a second object table (substrate table) WT provided with a substrate holder to hold a substrate W (e.g., a resist-coated silicon wafer), and connected to a second positioner to accurately position the substrate with respect to item PS;
- a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive patterning device). However, in general, it may also be of a reflective type, for example (with a reflective patterning device). The apparatus may employ a different kind of patterning device to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Fig. 12 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or F2 lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 12. However, in the case of a stepper (as opposed to a step-and-scan tool) the patterning device table MT may just be connected to a short stroke actuator, or may be fixed.

The depicted tool can be used in two different modes:
- In step mode, the patterning device table MT is kept essentially stationary, and an entire patterning device image is projected in one go (i.e., a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

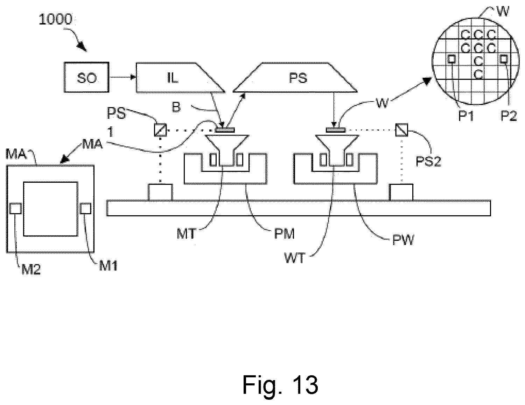

Fig. 13 depicts another exemplary lithographic projection apparatus 1000 in conjunction with the techniques described herein can be utilized.

The lithographic projection apparatus 1000 comprises:
- a source collector module SO
- an illumination system (illuminator) IL configured to condition a radiation beam B (e.g. EUV radiation).
- a support structure (e.g. a patterning device table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus 1000 is of a reflective type (e.g. employing a reflective patterning device). It is to be noted that because most materials are absorptive within the EUV wavelength range, the patterning device may have multilayer reflectors comprising, for example, a multi-stack of Molybdenum and Silicon. In one example, the multi-stack reflector has a 40-layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Referring to Fig. 13, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Fig. 13, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases, the source may be an integral part of the source collector module, for example when the source is a discharge produced plasma EUV generator, often termed as a DPP source.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

The depicted apparatus 1000 could be used in at least one of the following modes:
1. In step mode, the support structure (e.g. patterning device table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.
2. In scan mode, the support structure (e.g. patterning device table) MT and the substrate table WT are scanned synchronously while a pattern imparted to the radiation beam is projected onto a target portion C (i.e. a single dynamic exposure). The velocity and direction of the substrate table WT relative to the support structure (e.g. patterning device table) MT may be determined by the (de-)magnification and image reversal characteristics of the projection system PS.
3. In another mode, the support structure (e.g. patterning device table) MT is kept essentially stationary holding a programmable patterning device, and the substrate table WT is moved or scanned while a pattern imparted to the radiation beam is projected onto a target portion C. In this mode, generally a pulsed radiation source is employed, and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

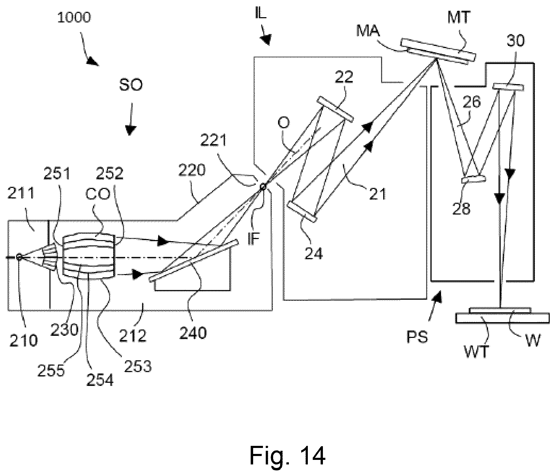

Fig. 14 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be 1- 6 additional reflective elements present in the projection system PS than shown in Fig. 12.

Collector optic CO, as illustrated in Fig. 12, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

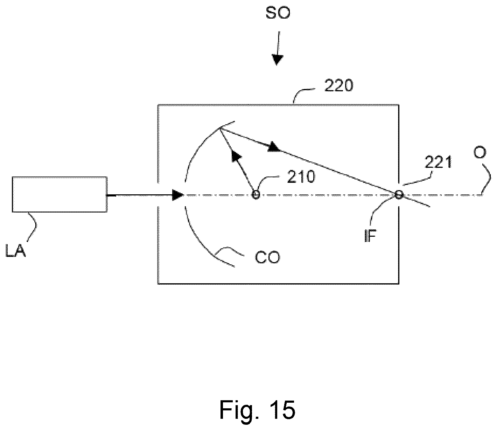

Alternatively, the source collector module SO may be part of an LPP radiation system as shown in Fig. 15. A laser LA is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

In selecting a set of patterns for training data to train the ML model, a particular number of special patterns and a particular number of representative patterns may be selected based on user input. For example, the user may input the number of special patterns and the number of representative patterns to be selected and the selection methods were selecting them accordingly. However, typically, the user may not know what number of special patterns or representative patterns is an optimal combination to obtain a good ML model coverage.

In the present disclosure, the image-based pattern selection process may facilitate automatic determination of an optimal number of special patterns to improve the ML model coverage. For example, in a semi-automatic pattern selection process, the user may provide a total number of patterns ("N") to be selected for the training data and the pattern selection method may automatically select a specified number of special patterns ("O") based on the distances (e.g., minimum distances) associated with input patterns and then determine a number of representative patterns ("K") to be selected from the remaining input patterns as a function of the total number of patterns to be selected and the specified number of special patterns selected (e.g., K=N-O) and select the number of representative patterns from the input patterns accordingly. In another example, a fully-automatic pattern selection process may include automatically selecting a specified number of patterns (e.g., including both special patterns and main patterns) based on the distances (e.g., minimum distances) associated with the input patterns. No user input regarding a number of the special patterns, main patterns or total patterns to be selected need to be provided.

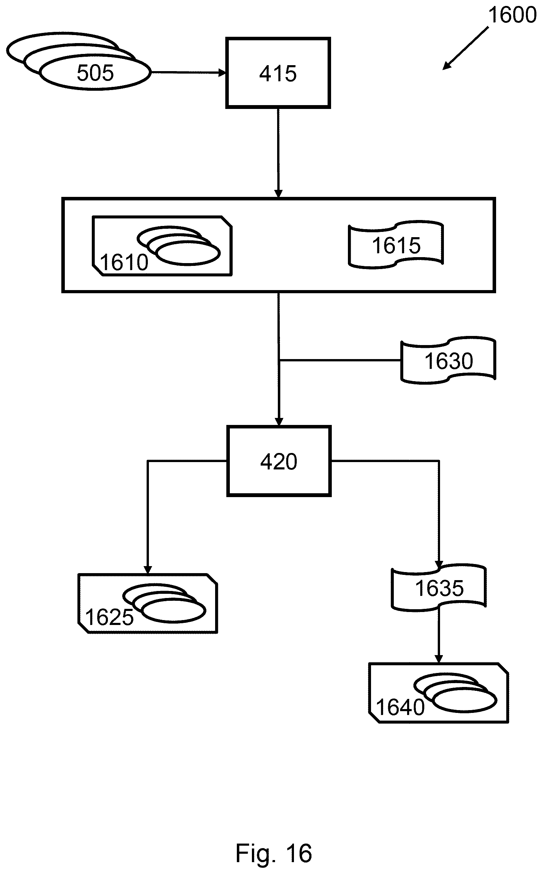

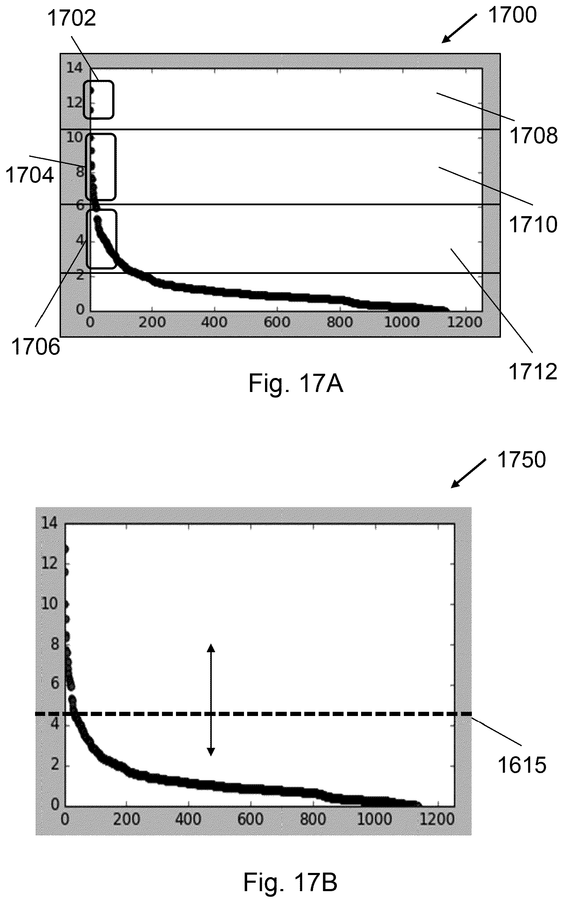

Figure 16 is a block diagram of an exemplary image-based pattern selection system 1600 for selecting patterns using a semi-automatic pattern selection process, consistent with various embodiments. In some embodiments, the image-based pattern selection system 1600 is similar to the image-based pattern selection system 400 of FIG. 4. The feature vectors 505 of various patterns are input to the grouping component 415. In some embodiments, the feature vectors 505 are representative of the patterns to be printed on a substrate and are generated from the pattern images 503 corresponding to those patterns. The grouping component 415 determines a minimum distance of a pattern from one or more other patterns in the pattern images 503 (e.g., by comparing their feature vectors as described above at least with reference to FIGs. 4 and 7) and classifies the patterns into categories based on the minimum distance of the patterns. In some embodiments, the grouping component 415 classifies the patterns by ranking the patterns based on their minimum distances (e.g., from large to small). For example, as illustrated in FIG. 17A, the grouping component 415 classifies the ranked patterns 1610 into categories 1700, such as a low-risk category 1712, a mid-risk category 1710, or a high-risk category 1708. The high-risk category 1708 may be representative of patterns (e.g., high-risk patterns 1702) associated with a minimum distance in a first range, the mid-risk category 1710 may be representative of patterns (e.g., mid-risk patterns 1704) associated with a minimum distance in a second range that is lesser than the first range, and the low-risk category 1712 may be representative of patterns (e.g., low-risk patterns 1706) associated with a minimum distance in a third range that is lesser than the second range. In some embodiments, the patterns in the high-risk category 1708 are more different from each other than the patterns in the mid-risk category 1710, which are more different from each other than the patterns in the low-risk category 1712. Also, the likelihood that the patterns in the high-risk category 1708 are special patterns is higher than the likelihood the patterns in the mid-risk category 1710 are special patterns, and the likelihood the patterns in the mid-risk category 1710 are special patterns is higher than the likelihood the patterns in the low-risk category 1712 are special patterns.

Note that while the example of FIG. 17A illustrates the ranked patterns 1610 categorized into three categories, the number of categories is not limited to three and may be more or less.

The grouping component 415 determines a threshold minimum distance 1615 that may be used for selection of patterns for the set of patterns 513, which may be used as training data for training the pattern predictor 430. In some embodiments, the threshold minimum distance 1615 is determined as a function of the minimum distances in the one or more categories and a count of patterns (e.g., number or quantity of patterns). For example, if there are no patterns in high-risk and mid-risk categories, the threshold minimum distance 1615 may be determined as a function of the greatest minimum distance in the low-risk category 1712 and the shortest minimum distance in the count of patterns. In another example, if there are no patterns in high-risk category, the threshold minimum distance 1615 may be determined as a function of the greatest minimum distance in the mid-risk category 1710 and the shortest distance in the count of patterns. In yet another example, if there are patterns in all categories, the threshold minimum distance 1615 may be determined as a function of the greatest minimum distance in the high-risk category 1708 and the shortest minimum distance in the count of patterns. In some embodiments, the threshold minimum distance 1615 may be determined using statistical distribution analysis. FIG. 17B shows a chart 1750 of the minimum distances of the patterns and a threshold minimum distance, consistent with various embodiments.

In some embodiments, the count of patterns to be considered for determining the threshold minimum distance 1615 may be based on (a) a total number of patterns (e.g., "N") 1630 to be included in the set of patterns 513 for semi-automatic pattern selection mode, and a total number of available patterns, e.g., in the ranked patterns 1610, for fully-automatic pattern selection mode.

The pattern selector 420 selects all patterns having minimum distances above the threshold minimum distance 1615 as special patterns 1625. Typically, if there are patterns in the high-risk category 1708, all patterns from the high-risk category 1708 are selected regardless of the value of the threshold minimum distance 1615.

In some embodiments, the patterns having minimum distances below the threshold minimum distance 1615 may be grouped into groups of main patterns 509. For example, the grouping component 415 groups the main patterns into clusters 910-930 (e.g., using k-means algorithm) as illustrated in FIG. 10. After the special patterns 1625 are selected, the pattern selector 420 determines the number (e.g., a count) of representative patterns to be selected for inclusion in the set of patterns 513. In some embodiments, the pattern selector 420 determines the number of representative patterns 1635 ("K") to be selected as a difference between the total number of patterns 1630 to be included in the set of patterns 513 and the number of special patterns 1625 selected (e.g., K=N-O). The pattern selector 420 selects "K" number of representative patterns 1640 from the groups of main patterns 509. For example, the pattern selector 420 selects representative patterns 1012, 1022 and 1032 from the clusters 910-930 as representative patterns 1640.

The special patterns 1625 and the representative patterns 1640 may be selected as the set of patterns 513. The feature vectors 505 corresponding to the selected set of patterns 513 may be stored in the data storage system 425, and may be used as training data for training the pattern predictor 430 to predict a pattern to be printed on the substrate for a given target pattern.

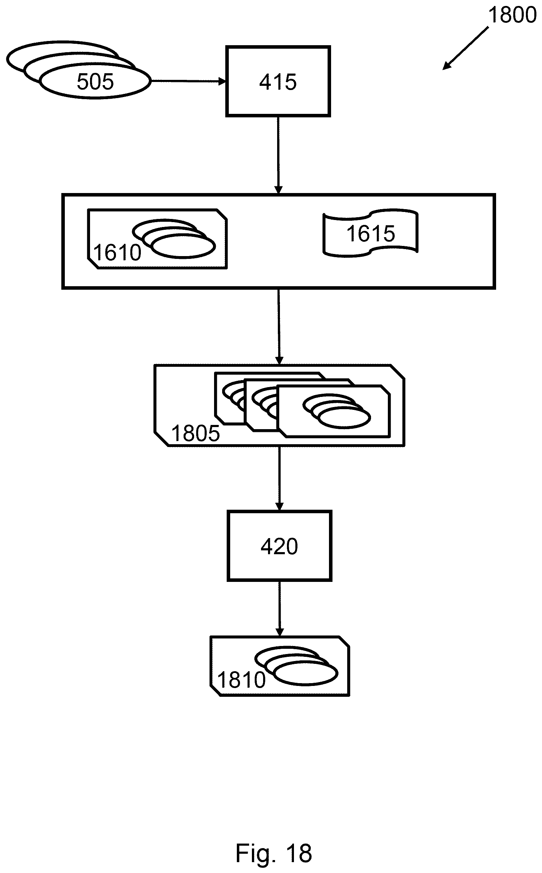

Figure 18 is a block diagram of an exemplary image-based pattern selection system 1600 for selecting patterns using a fully-automatic pattern selection mode, consistent with various embodiments. In some embodiments, the image-based pattern selection system 1800 is similar to the image-based pattern selection system 1600 of FIG. 16. As described above with reference to FIG. 16, the threshold minimum distance 1615 is determined as a function of the minimum distances in the one or more categories and a count of patterns (e.g., a number or quantity of patterns), and for fully-automatic pattern selection mode, the count of patterns considered may be based on a total number of available patterns, e.g., count of patterns in the ranked patterns 1610.

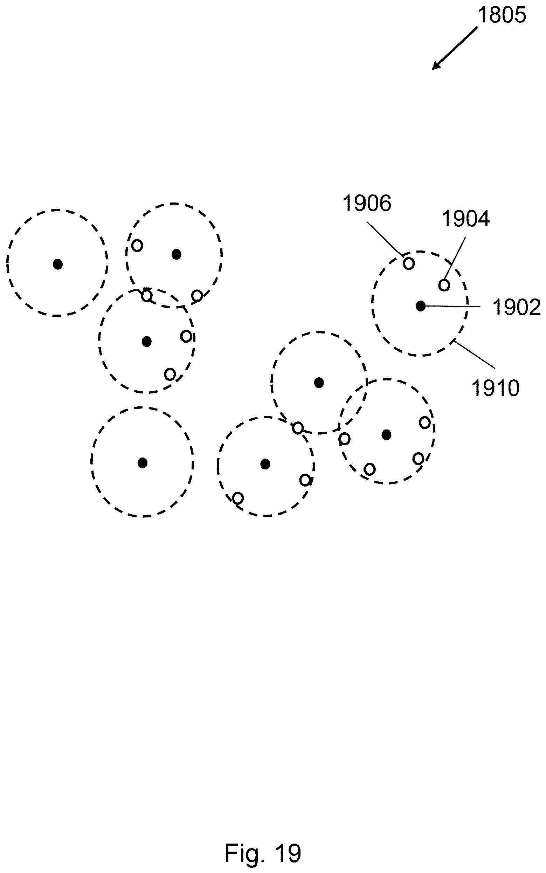

After determining the threshold minimum distance 1615, the grouping component 415 groups the patterns from the ranked patterns 1610 to multiple groups 1805 based on the threshold minimum distance 1615. FIG. 19 shows an example of the groups 1805 formed based on a threshold minimum distance, consistent with various embodiments. The groups 1805 may include multiple groups in which each group includes patterns that have minimum distances from each other within the threshold minimum distance 1615. For example, a first group 1910 includes patterns 1902, 1904 and 1906 whose minimum distances from each other are within the threshold minimum distance 1615.

The pattern selector 420 may select at least one pattern from each of the groups 1805 to obtain patterns 1810, which may be selected as the set of patterns 513. For example, the pattern selector 420 may select the pattern 1902 from the first group 1910. In some embodiments, the patterns 1805 may be grouped and the patterns 1810 may be selected using linear programming methods. The feature vectors 505 corresponding to the selected set of patterns 513 may be stored in the data storage system 425, and may be used as training data for training the pattern predictor 430 to predict a pattern to be printed on the substrate for any given target pattern.

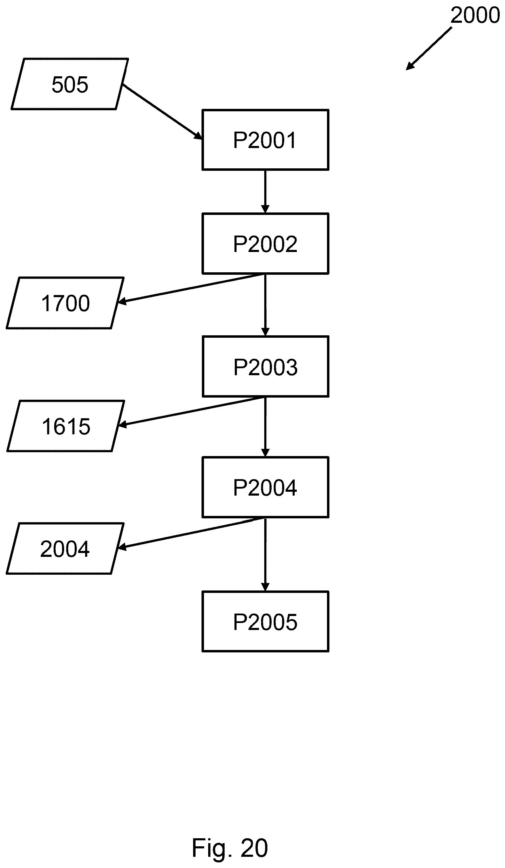

Figure 20 is a flow chart of an exemplary method 2000 for automatic selection of patterns, consistent with various embodiments. In some embodiments, the method 2000 may be implemented by the system 1600 or 1800 of FIGs. 16 or 18.

At process P2001, the feature vectors 505 of various patterns are obtained. In some embodiments, the feature vectors 505 are representative of the patterns to be printed on a substrate and are generated from the pattern images 503 corresponding to those patterns.

At process P2002, the patterns are classified into categories 1700 based on the minimum distance value associated with the patterns. In some embodiments, the minimum distance is determined based on the feature vectors as described above at least with reference to FIGs. 4 and 7. The categories 1700 may include categories such as a low-risk category 1712, a mid-risk category 1710, or a high-risk category 1708 in which each category is associated with a different range of minimum distances and comprises patterns having a minimum distance in the corresponding range.

At process P2003, a threshold minimum distance 1615 is determined. The threshold minimum distance may be used for selection of patterns for the set of patterns 513 that is used as training data for training the pattern predictor 430. In some embodiments, the threshold minimum distance 1615 is determined as a function of the minimum distances in the one or more categories and a count of patterns (e.g., determined based on a number or quantity of patterns in the ranked patterns 1610 or number of patterns to be included in the set of patterns 513).

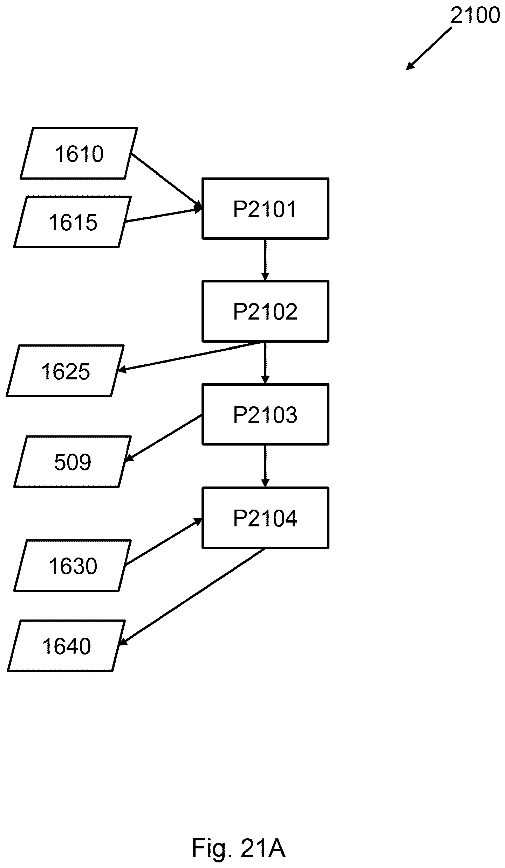

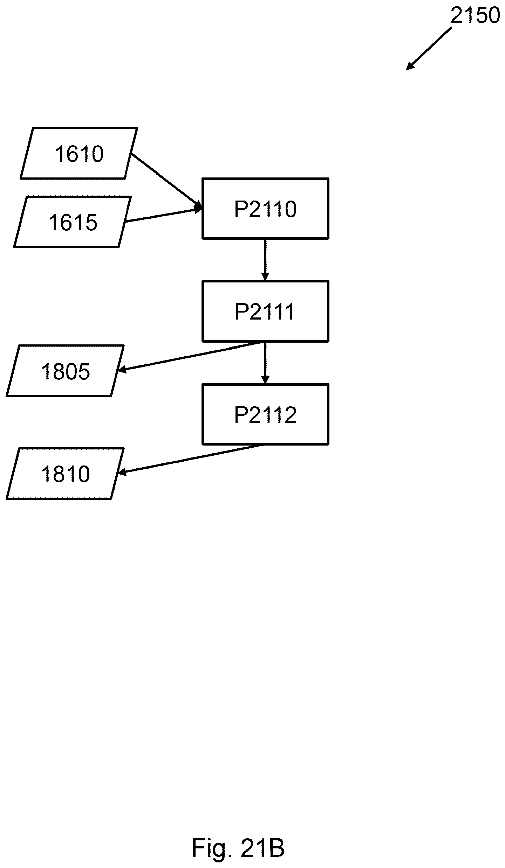

At process P2004, patterns 2004 are selected based on the threshold minimum distance 1615. Additional details with respect to the selection of the patterns 2004 is described at least with reference to Figures. 21A and 21B below.

At process P2005, the selected patterns 2004 are output as the set of patterns 513 that is used as training data for training the pattern predictor 430.

Figure 21A is a flow diagram of an exemplary method 2100 for selecting patterns using a semi-automatic pattern selection mode, consistent with various embodiments. In some embodiments, the method 2100 may be implemented by the system 1600 of FIG. 16, and as part of process P2004 of method 2000 of Figures. 20.

At process P2101, the ranked patterns 1610 and the threshold minimum distance 1615 are obtained. Note that, for the semi-automatic mode, the threshold minimum distance 1615 may be determined as a function of the minimum distances in the one or more categories and a count of patterns (e.g., a total number or quantity of patterns to be selected for the set of patterns 513).

At process P2102, the special patterns 1625 are obtained based on the threshold minimum distance. For example, the pattern selector 420 selects all patterns having minimum distances above the threshold minimum distance 1615 as special patterns 1625.

At process P2103, the remaining patterns, e.g., patterns that are below the threshold minimum distance 1615, are clustered into multiple groups of main patterns 509. For example, the grouping component 415 groups the remaining patterns into clusters 910-930 (e.g., using k-means algorithm) as illustrated in FIG. 10.

At process P2104, a count of the patterns, "N," to be included in the set of patterns 513 is obtained (e.g., as user input) and the number of representative patterns 1640 from the groups of main pattern 509 to be selected is determined based on the count of the patterns and a count of the special patterns 1625. For example, the pattern selector 420 determines the number of representative patterns 1635 ("K") to be selected as a difference between the total number of patterns 1630 to be included in the set of patterns 513 and the number of special patterns 1625 selected (e.g., K=N-O). The pattern selector 420 selects "K" number of representative patterns 1640 from the groups of main patterns 509. For example, the pattern selector 420 selects representative patterns 1012, 1022 and 1032 from the clusters 910-930 as representative patterns 1640. The special patterns 1625 and the representative patterns 1640 are then included in the set of patterns 513.

Figure 21B is a flow diagram of an exemplary method 2150 for selecting patterns using a fully-automatic pattern selection mode, consistent with various embodiments. In some embodiments, the method 2150 may be implemented by the system 1800 of FIG. 18, and as part of process P2004 of method 2000 of FIG. 20.

At process P2110, the ranked patterns 1610 and the threshold minimum distance 1615 are obtained. Note that, for the fully-automatic mode, the threshold minimum distance 1615 may be determined as a function of the minimum distances in the one or more categories and a count of patterns (e.g., a total number or quantity of patterns available in the ranked patterns 1610).

At process P2111, the patterns from the ranked patterns 1610 are grouped into multiple groups 1805 based on the threshold minimum distance 1615. Each group includes patterns that have minimum distances from each other within the threshold minimum distance 1615. For example, as illustrated in FIG. 19, a first group 1910 includes patterns 1902, 1904 and 1906 whose minimum distances from each other are within the threshold minimum distance 1615.

At process P2112, at least one pattern from each of the groups 1805 is selected to obtain patterns 1810, which may be selected as the set of patterns 513. For example, the pattern selector 420 may select the pattern 1902 from the first group 1910. In some embodiments, the patterns 1805 may be grouped and the patterns 1810 may be selected using linear programming methods.

According to present disclosure, the combination and sub-combinations of disclosed elements constitute separate embodiments. For example, a first combination includes selecting training data to train a ML model (e.g., predictor 450) to predict patterns to be printed on a substrate. In a sub-combination, the embodiments may include improving a model coverage of the ML model and an accuracy in predict the patterns to be printed on the substrate. A second combination may include selecting the patterns for training data using a semi-automatic pattern selection mode. A third combination may include selecting the patterns for training data using a fully-automatic pattern selection mode.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The concepts disclosed herein may simulate or mathematically model any generic imaging system for imaging sub wavelength features, and may be especially useful with emerging imaging technologies capable of producing wavelengths of an increasingly smaller size. Emerging technologies already in use include EUV (extreme ultraviolet) lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

It shoud be understood that the description and the drawings are not intended to limit the present disclosure to the particular form disclosed.

Modifications and alternative embodiments of various aspects of the invention will be apparent to those skilled in the art in view of this description. Accordingly, this description and the drawings are to be construed as illustrative only and are for the purpose of teaching those skilled in the art the general manner of carrying out the invention. It is to be understood that the forms of the invention shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the scope of the present disclosures. The invention is defined by the appended claims.

## Claims

1. A non-transitory computer-readable medium having instructions that, when executed by a computer, cause the computer to execute a method of pattern selection, the method comprising:
obtaining images of multiple patterns, wherein the multiple patterns correspond to target patterns to be printed on a substrate and the images are simulated images comprising at least one of: resist images, mask images, aerial images and etch images; and
selecting a set of patterns from the multiple patterns based on the images as training data for training a first model, wherein the first model is a resist model, an etch model, or a combination thereof, the first model being able to predict patterns to be printed on a substrate through lithography.

2. The computer-readable medium of claim 1, wherein selecting the set of patterns includes grouping the multiple patterns into main patterns and special patterns respectively by using different clustering algorithms.

3. The computer-readable medium of claim 2, wherein grouping the multiple patterns includes:
generating a group of special patterns and multiple groups of main patterns from the multiple patterns, wherein generating the group of special patterns includes:
grouping the multiple patterns based on a distance between feature vectors of the multiple patterns, wherein a distance between two feature vectors of the feature vectors is indicative of a difference between two patterns in the corresponding two images.

4. The computer-readable medium of claim 3, wherein generating the group of special patterns includes:
clustering the feature vectors based on density-based spatial clustering to identify a set of feature vectors as outliers; and
determining patterns in the images corresponding to the set of feature vectors as the group of special patterns.

5. The computer-readable medium of claim 3, wherein generating the multiple groups of main patterns includes:
determining those of the feature vectors not in the group of special patterns as a set of feature vectors corresponding to main patterns; and
clustering the set of feature vectors into the multiple groups of main patterns.

6. The computer-readable medium of claim 3, wherein selecting the set of patterns from the multiple groups includes:
selecting the group of special patterns and a representative main pattern from each group of main patterns,
wherein selecting the representative main pattern from each group of main patterns includes:
determining, for each group of main patterns, a centroid of the corresponding group of main patterns; and
determining, for each group of main patterns, a feature vector that is closest to the centroid as a representative main pattern of the corresponding group of main patterns.

7. The computer-readable medium of claim 6, further comprising:
training the first model using the images corresponding to the group of special patterns and the representative main patterns to generate a simulated pattern to be printed on the substrate.

8. The computer-readable medium of claim 5, wherein the feature vectors are generated by executing a second model, using a set of pattern images, to output a predicted feature vector for a first pattern image of the set of pattern images.

9. The computer-readable medium of claim 1, wherein the obtained images are resist images, and wherein obtaining the images of the multiple patterns includes:
generating, using the pattern data, aerial images of the multiple patterns from a source model that is representative of optical properties of a lithographic apparatus; and
generating, using the pattern data, resist images of the multiple patterns from aerial images using a resist model, wherein
the pattern data includes at least one of a full-chip layout data, location data of the multiple patterns in the full-chip layout, or focus exposure matrix data.

10. The computer-readable medium of claim 1, wherein selecting
the set of patterns includes:
determining a minimum distance of each pattern from any other patterns; and
classifying the patterns into one or more categories based on a distribution of the minimum distances of the patterns.

11. The computer-readable medium of claim 10, wherein classifying the patterns includes:
determining a threshold minimum distance as a function of a greatest minimum distance in the one or more categories, wherein the threshold minimum distance is used for a selection of the patterns to be included in the set of patterns.

12. The computer-readable medium of claim 10, wherein special patterns from a first category that have a minimum distance above the threshold minimum distance are selected, wherein the threshold minimum distance is determined as a function of the greatest minimum distance in the first category.

13. The computer-readable medium of claim 2, wherein selecting the set of patterns includes:
determining a number of representative main patterns to be included in the set of patterns as a function of the specified number of special patterns and the total number of patterns to be included in the set of patterns; and
outputting the set of patterns with the number of representative main patterns.

14. The computer-readable medium of claim 11 further comprising:
determining the threshold minimum distance based on a shortest minimum distance among a total number of the patterns;
grouping the patterns into multiple collections based on the threshold minimum distance, wherein each collection includes one or more patterns each having a minimum distance that is below the threshold minimum distance from any other pattern in the collection;
selecting at least one pattern from each collection to be included in the set of patterns; and
outputting the set of patterns with the at least one pattern from each collection.

15. The computer-readable medium of claim 1, wherein the first model is a machine learning model, a non-machine learning model, or a combination thereof.

## Patentansprüche

1. Ein nichttransitorisches computerlesbares Medium, das Anweisungen aufweist, die bei Ausführung durch einen Computer bewirken, dass der Computer ein Musterauswahlverfahren ausführt, wobei das Verfahren Folgendes beinhaltet:
Erhalten von Bildern mehrerer Muster, wobei die mehreren Muster auf ein Substrat zu druckenden Zielmustern entsprechen und die Bilder simulierte Bilder sind, die mindestens eines von Folgendem beinhalten: Resistbilder, Maskenbilder, Luftbilder und Ätzbilder; und
Auswählen eines Satzes Muster aus den mehreren Mustern auf der Basis der Bilder als Trainingsdaten zum Trainieren eines ersten Modells, wobei das erste Modell ein Resistmodell,
ein Ätzmodell oder eine Kombination davon ist, wobei das erste Modell fähig ist, mittels Lithographie auf ein Substrat zu druckende Muster vorherzusagen.

2. Computerlesbares Medium gemäß Anspruch 1, wobei das Auswählen des Satzes Muster das Gruppieren der mehreren Muster in Hauptmuster bzw. Spezialmuster durch Verwendung unterschiedlicher Clusteringalgorithmen umfasst.

3. Computerlesbares Medium gemäß Anspruch 2, wobei das Gruppieren der mehreren Muster Folgendes umfasst:
Erzeugen einer Gruppe von Spezialmustern und mehrerer Gruppen von Hauptmustern aus den mehreren Mustern, wobei das Erzeugen der Gruppe von Spezialmustern Folgendes umfasst:
Gruppieren der mehreren Muster auf der Basis einer Distanz zwischen Merkmalsvektoren der mehreren Muster, wobei eine Distanz zwischen zwei Merkmalsvektoren der Merkmalsvektoren für eine Differenz zwischen zwei Mustern in den entsprechenden zwei Bildern indikativ ist.

4. Computerlesbares Medium gemäß Anspruch 3, wobei das Erzeugen der Gruppe von Spezialmustern Folgendes umfasst:
Clustering der Merkmalsvektoren auf der Basis dichtebasierten räumlichen Clusterings, um einen Satz Merkmalsvektoren als Ausreißer zu identifizieren; und
Bestimmen von Mustern in den Bildern, die dem Satz Merkmalsvektoren entsprechen, als die Gruppe von Spezialmustern.

5. Computerlesbares Medium gemäß Anspruch 3, wobei das Erzeugen der mehreren Gruppen von Hauptmustern Folgendes umfasst:
Bestimmen derjenigen Merkmalsvektoren, die nicht zu der Gruppe von Spezialmustern gehören, als einen den Hauptmustern entsprechenden Satz Merkmalsvektoren; und
Clustering des Satzes Merkmalsvektoren in die mehreren Gruppen von Hauptmustern.

6. Computerlesbares Medium gemäß Anspruch 3, wobei das Auswählen des Satzes Muster aus den mehreren Gruppen Folgendes umfasst:
Auswählen der Gruppe von Spezialmustern und eines repräsentativen Hauptmusters aus jeder Gruppe von Hauptmustern,
wobei das Auswählen des repräsentativen Hauptmusters aus jeder Gruppe von Hauptmustern Folgendes umfasst:
Bestimmen, für jede Gruppe von Hauptmustern, eines Schwerpunkts der entsprechenden Gruppe von Hauptmustern; und
Bestimmen, für jede Gruppe von Hauptmustern, eines Merkmalsvektors, der dem Schwerpunkt am nächsten ist, als ein repräsentatives Hauptmuster der entsprechenden Gruppe von Hauptmustern.

7. Computerlesbares Medium gemäß Anspruch 6, das ferner Folgendes beinhaltet:
Trainieren des ersten Modells unter Verwendung der Bilder, die der Gruppe von Spezialmustern und den repräsentativen Hauptmustern entsprechen, um ein simuliertes auf das Substrat zu druckendes Muster zu erzeugen.

8. Computerlesbares Medium gemäß Anspruch 5, wobei die Merkmalsvektoren durch das Ausführen eines zweiten Modells unter Verwendung eines Satzes Musterbilder zum Ausgeben eines vorhergesagten Merkmalsvektors für ein erstes Musterbild des Satzes Musterbilder erzeugt werden.

9. Computerlesbares Medium gemäß Anspruch 1, wobei die erhaltenen Bilder Resistbilder sind und wobei das Erhalten der Bilder der mehreren Muster Folgendes umfasst:
Erzeugen, unter Verwendung der Musterdaten, von Luftbildern der mehreren Muster aus einem Quellenmodell, das für optische Eigenschaften einer lithographischen Vorrichtung repräsentativ ist; und
Erzeugen, unter Verwendung der Musterdaten, von Resistbildern der mehreren Muster aus Luftbildern unter Verwendung eines Resistmodells, wobei
die Musterdaten mindestens eines von Voll-Chip-Layoutdaten, Ortsangabedaten der mehreren Muster in dem Voll-Chip-Layout oder Fokusbelichtungsmatrixdaten umfassen.

10. Computerlesbares Medium gemäß Anspruch 1, wobei das Auswählen des Satzes Muster Folgendes umfasst:
Bestimmen einer Minimaldistanz jedes Musters von jedem anderen Muster; und
Klassifizieren der Muster in eine oder mehrere Kategorien auf der Basis einer Verteilung der Minimaldistanzen der Muster.

11. Computerlesbares Medium gemäß Anspruch 10, wobei das Klassifizieren der Muster Folgendes umfasst:
Bestimmen einer Schwellenwertminimaldistanz als eine Funktion einer größten Minimaldistanz in der einen oder den mehreren Kategorien, wobei die Schwellenwertminimaldistanz für eine Auswahl der in dem Satz Muster einzuschließenden Muster verwendet wird.

12. Computerlesbares Medium gemäß Anspruch 10, wobei Spezialmuster aus einer ersten Kategorie, die eine Minimaldistanz über der Schwellenwertminimaldistanz aufweisen, ausgewählt werden, wobei die Schwellenwertminimaldistanz als eine Funktion der größten Minimaldistanz in der ersten Kategorie bestimmt wird.

13. Computerlesbares Medium gemäß Anspruch 2, wobei das Auswählen des Satzes Muster Folgendes umfasst:
Bestimmen einer Anzahl von in dem Satz Muster einzuschließenden repräsentativen Hauptmustern als eine Funktion der spezifizierten Anzahl von Spezialmustern und der Gesamtzahl von in dem Satz Muster einzuschließenden Mustern; und
Ausgeben des Satzes Muster mit der Anzahl von repräsentativen Hauptmustern.

14. Computerlesbares Medium gemäß Anspruch 11, das ferner Folgendes beinhaltet:
Bestimmen der Schwellenwertminimaldistanz auf der Basis einer kürzesten Minimaldistanz aus einer Gesamtzahl der Muster;
Gruppieren der Muster in mehrere Sammlungen auf der Basis der Schwellenwertminimaldistanz, wobei jede Sammlung ein oder mehrere Muster umfasst, die jeweils eine Minimaldistanz aufweisen, die unter der Schwellenwertminimaldistanz von jedem anderen Muster in der Sammlung liegt;
Auswählen mindestens eines in dem Satz Muster einzuschließenden Musters aus jeder Sammlung; und
Ausgeben des Satzes Muster mit dem mindestens einen Muster aus jeder Sammlung.

15. Computerlesbares Medium gemäß Anspruch 1, wobei das erste Modell ein Maschinenlernmodell, ein Nicht-Maschinenlernmodell oder eine Kombination davon ist.

## Revendications

1. Un support lisible par ordinateur non transitoire ayant des instructions qui, lorsqu'elles sont exécutées par un ordinateur, amènent l'ordinateur à exécuter un procédé de sélection de motif, le procédé comprenant :
le fait d'obtenir des images de motifs multiples, où les motifs multiples correspondent à des motifs cibles devant être imprimés sur un substrat et les images sont des images simulées comprenant : des images de réserve, et/ou des images de masque, et/ou des images aériennes et/ou des images de gravure ; et
le fait de sélectionner un ensemble de motifs parmi les motifs multiples sur la base des images comme données d'entraînement pour entraîner un premier modèle, où le premier modèle est un modèle de réserve, un modèle de gravure, ou une combinaison de ceux-ci, le premier modèle étant apte à prédire des motifs devant être imprimés sur un substrat par lithographie.

2. Le support lisible par ordinateur de la revendication 1, où le fait de sélectionner l'ensemble de motifs inclut le fait de grouper les motifs multiples en motifs principaux et motifs spéciaux respectivement grâce à l'utilisation de différents algorithmes de regroupement.

3. Le support lisible par ordinateur de la revendication 2, où le fait de grouper les motifs multiples inclut :
le fait de générer un groupe de motifs spéciaux et des groupes multiples de motifs principaux à partir des motifs multiples, où le fait de générer le groupe de motifs spéciaux inclut :
le fait de grouper les motifs multiples sur la base d'une distance entre des vecteurs de caractéristiques des motifs multiples, où une distance entre deux vecteurs de caractéristiques des vecteurs de caractéristiques est indicative d'une différence entre deux motifs dans les deux images correspondantes.

4. Le support lisible par ordinateur de la revendication 3, où le fait de générer le groupe de motifs spéciaux inclut :
le fait de regrouper les vecteurs de caractéristiques sur la base d'un regroupement spatial basé sur la densité afin d'identifier un ensemble de vecteurs de caractéristiques comme valeurs aberrantes ; et
le fait de déterminer que des motifs dans les images correspondant à l'ensemble de vecteurs de caractéristiques constituent le groupe de motifs spéciaux.

5. Le support lisible par ordinateur de la revendication 3, où le fait de générer les groupes multiples de motifs principaux inclut :
le fait de déterminer que ceux des vecteurs de caractéristiques qui n'appartiennent pas au groupe de motifs spéciaux constituent un ensemble de vecteurs de caractéristiques correspondant à des motifs principaux ; et
le fait de regrouper l'ensemble de vecteurs de caractéristiques dans les groupes multiples de motifs principaux.

6. Le support lisible par ordinateur de la revendication 3, où le fait de sélectionner l'ensemble de motifs parmi les groupes multiples inclut :
le fait de sélectionner le groupe de motifs spéciaux et un motif principal représentatif parmi chaque groupe de motifs principaux,
où le fait de sélectionner le motif principal représentatif parmi chaque groupe de motifs principaux inclut :
le fait de déterminer, pour chaque groupe de motifs principaux, un centroïde du groupe de motifs principaux correspondant ; et
le fait de déterminer, pour chaque groupe de motifs principaux, qu'un vecteur de caractéristiques qui est le plus proche du centroïde constitue un motif principal représentatif du groupe de motifs principaux correspondant.

7. Le support lisible par ordinateur de la revendication 6, comprenant en sus :
le fait d'entraîner le premier modèle en utilisant les images correspondant au groupe de motifs spéciaux et aux motifs principaux représentatifs afin de générer un motif simulé devant être imprimé sur le substrat.

8. Le support lisible par ordinateur de la revendication 5, où les vecteurs de caractéristiques sont générés par exécution d'un deuxième modèle, en utilisant un ensemble d'images de motif, afin de produire en sortie un vecteur de caractéristiques prédit pour une première image de motif de l'ensemble d'images de motif.

9. Le support lisible par ordinateur de la revendication 1, où les images obtenues sont des images de réserve, et où le fait d'obtenir les images des motifs multiples inclut :
le fait de générer, en utilisant les données de motif, des images aériennes des motifs multiples à partir d'un modèle source qui est représentatif de propriétés optiques d'un appareil lithographique ; et
le fait de générer, en utilisant les données de motif, des images de réserve des motifs multiples à partir d'images aériennes en utilisant un modèle de réserve, où
les données de motif incluent des données de tracé de puce entière, et/ou des données de localisation des motifs multiples dans le tracé de puce entière, et/ou des données de matrice d'exposition en focus.

10. Le support lisible par ordinateur de la revendication 1, où le fait de sélectionner l'ensemble de motifs inclut :
le fait de déterminer une distance minimale de chaque motif par rapport à tout autre motif ; et
le fait de classer les motifs dans une ou plusieurs catégories sur la base d'une distribution des distances minimales des motifs.

11. Le support lisible par ordinateur de la revendication 10, où le fait de classer les motifs inclut :
le fait de déterminer une distance minimale seuil en fonction d'une distance minimale la plus grande dans les une ou plusieurs catégories, où la distance minimale seuil est utilisée pour une sélection des motifs devant être inclus dans l'ensemble de motifs.

12. Le support lisible par ordinateur de la revendication 10, où des motifs spéciaux issus d'une première catégorie qui ont une distance minimale au-dessus de la distance minimale seuil sont sélectionnés, où la distance minimale seuil est déterminée en fonction de la distance minimale la plus grande dans la première catégorie.

13. Le support lisible par ordinateur de la revendication 2, où le fait de sélectionner l'ensemble de motifs inclut :
le fait de déterminer un nombre de motifs principaux représentatifs devant être inclus dans l'ensemble de motifs en fonction du nombre spécifié de motifs spéciaux et du nombre total de motifs devant être inclus dans l'ensemble de motifs ; et
le fait de produire en sortie l'ensemble de motifs avec le nombre de motifs principaux représentatifs.

14. Le support lisible par ordinateur de la revendication 11 comprenant en sus :
le fait de déterminer la distance minimale seuil sur la base d'une distance minimale la plus courte parmi un nombre total des motifs ;
le fait de grouper les motifs en collections multiples sur la base de la distance minimale seuil, où chaque collection inclut un ou plusieurs motifs ayant chacun une distance minimale qui est en dessous de la distance minimale seuil par rapport à tout autre motif dans la collection ;
le fait de sélectionner au moins un motif issu de chaque collection devant être inclus dans l'ensemble de motifs ; et
le fait de produire en sortie l'ensemble de motifs avec l'au moins un motif issu de chaque collection.

15. Le support lisible par ordinateur de la revendication 1, où le premier modèle est un modèle d'apprentissage automatique, un modèle d'apprentissage non automatique, ou une combinaison de ceux-ci.
